(19) Europäisches Patentamt
European Patent Office
Office européen des brevets

(11) EP 3 017 487 B1

(12) EUROPÄISCHE PATENTSCHRIFT

(45) Veröffentlichungstag und Bekanntmachung des Hinweises auf die Patenterteilung:
**13.01.2021 Patentblatt 2021/02**

(21) Anmeldenummer: **14729594.3**

(22) Anmeldetag: **11.06.2014**

(51) Int Cl.:
***H01L 51/54*** *(2006.01)* ***C09K 11/06*** *(2006.01)*

(86) Internationale Anmeldenummer:
**PCT/EP2014/001586**

(87) Internationale Veröffentlichungsnummer:
**WO 2015/000548 (08.01.2015 Gazette 2015/01)**

(54) **ORGANISCHE ELEKTROLUMINESZENZVORRICHTUNG**

ORGANIC ELECTROLUMINESCENT DEVICE

DISPOSITIF ÉLECTROLUMINESCENT ORGANIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **02.07.2013 EP 13003342**

(43) Veröffentlichungstag der Anmeldung:
**11.05.2016 Patentblatt 2016/19**

(73) Patentinhaber: **Merck Patent GmbH**
**64293 Darmstadt (DE)**

(72) Erfinder:
- **KAISER, Joachim**
  **64289 Darmstadt (DE)**
- **PFLUMM, Christof**
  **64291 Darmstadt (DE)**
- **PARHAM, Amir, Hossain**
  **60486 Frankfurt am Main (DE)**
- **EBERLE, Thomas**
  **76829 Landau (DE)**
- **STOESSEL, Philipp**
  **60487 Frankfurt am Main (DE)**
- **KROEBER, Jonas, Valentin**
  **60311 Frankfurt am Main (DE)**
- **JATSCH, Anja**
  **60489 Frankfurt am Main (DE)**
- **BECKER, Heinrich**
  **64372 Ober-Ramstadt (DE)**
- **LINGE, Rouven**
  **64291 Darmstadt (DE)**

(56) Entgegenhaltungen:
**WO-A1-2013/084881 WO-A1-2013/084885**
**US-A1- 2013 112 920**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 3 017 487 B1

## Beschreibung

Die vorliegende Erfindung betrifft organische Elektrolumineszenzvorrichtungen, welche in der emittierenden Schicht eine Mischung aus einem Iridiumkomplex und einer Triazin- bzw. Pyrimidinverbindung enthält.

Der Aufbau organischer Elektrolumineszenzvorrichtungen (OLEDs), in denen organische Halbleiter als funktionelle Materialien eingesetzt werden, ist beispielsweise in US 4539507, US 5151629, EP 0676461 und WO 98/27136 beschrieben. Als emittierende Materialien werden hierbei zunehmend metallorganische Komplexe eingesetzt, die Phosphoreszenz statt Fluoreszenz zeigen (M. A. Baldo et al., Appl. Phys. Lett. 1999, 75, 4-6). Aus quantenmechanischen Gründen ist unter Verwendung metallorganischer Verbindungen als Phosphoreszenzemitter eine bis zu vierfache Energie- und Leistungseffizienz möglich.

Die Eigenschaften von phosphoreszierenden OLEDs werden nicht nur von den eingesetzten Triplettemittern bestimmt. Hier sind auch die anderen verwendeten Materialien, insbesondere auch die Matrixmaterialien von besonderer Bedeutung. Verbesserungen dieser Materialien bzw. insbesondere auch der Kombination von Triplettemitter und Matrixmaterial können somit auch zu deutlichen Verbesserungen der OLED-Eigenschaften führen.

Insbesondere gibt es noch Verbesserungsbedarf bei der Betriebslebensdauer von phosphoreszenten gelben OLEDs und OLEDs, die gelbe Emission mit einer anderen Farbe kombinieren, um z. B. weißes Licht zu erhalten. Dies gilt insbesondere im Hinblick auf TV-Anwendungen basierend auf Weiß+Farbfilter Technologie, da hierbei durch die Verwendung des Farbfilters ein beträchtlicher Teil des emittierten Lichts absorbiert wird und die zugrunde liegende gelbe bzw. weiße OLED bei erhöhter Helligkeit betrieben werden muss, was sich in eine erhöhte Anforderung bezüglich der Betriebslebensdauer übersetzt. Dies gilt ebenso für Beleuchtungsanwendungen, da hier der Trend weg von den in den vergangenen Jahren demonstrierten 1000 $cd/m^2$ Lichtkacheln zu immer höheren Leuchtdichten im Bereich von bis zu 5000 $cd/m^2$ geht.

Die der vorliegenden Erfindung zugrunde liegende technische Aufgabe ist somit die Bereitstellung von OLEDs mit einer verbesserten Lebensdauer, insbesondere von gelb und weiß emittierenden OLEDs.

Überraschend wurde gefunden, dass organische Elektrolumineszenzvorrichtungen, welche in der emittierenden Schicht einen Iridiumkomplex mit gegebenenfalls substituierten Benzochinolinliganden und eine Triazin- bzw. Pyrimidinverbindung gemäß der vorliegenden Anmeldung aufweist, diese Aufgabe löst und zu exzellenten Lebensdauern im Bereich von bis zu 1 Million Stunden führt. Damit ist die Lebensdauer um einen Faktor von bis zu 3 bis 5 besser im Vergleich zu anderen Matrixmaterialien.

Aus WO 2013/084885 und WO 2013/084881 sind OLEDs bekannt, welche als Emitter einen Iridiumkomplex mit drei Benzochinolinliganden enthält und welche ein Mixed Host System aus einem Cyano-substituierten Biscarbazolderivat und einer Verbindung mit einem Carbazol und einem Stickstoff-haltigen Ring enthält.

Aus US 2013/0112920 ist eine OLED bekannt, welche einen heteroleptischen Iridiumkomplex mit einem Benzochinolinliganden enthält und welche als Host ein Indenocarbazol, welches mit Diphenyltriazin substituiert ist, enthält.

Benzochinolin im Sinne der vorliegenden Erfindung weist die folgende Struktur auf:

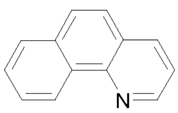 .

Iridiumkomplexe mit Benzochinolinliganden sind beispielsweise bekannt aus EP 1353388, EP 1267428 oder US 2001/0019782. Die Verwendung dieser Komplexe in Kombination mit Triazin- oder Pyrimidinliganden ist weder offenbart noch nahegelegt. Insbesondere ist eine Steigerung der Lebensdauer wie im vorliegenden Fall weder mit einer anderen Matrix erhalten worden, noch wäre eine solche Lebensdauersteigerung aus dem Stand der Technik vorherzusehen gewesen.

Organische Elektrolumineszenzvorrichtungen, enthaltend eine solche Mischung, sind somit der Gegenstand der vorliegenden Erfindung.

Gegenstand der Erfindung ist somit eine organische Elektrolumineszenzvorrichtung, enthaltend in der emittierenden Schicht eine Mischung aus einem Iridiumkomplex, welcher mindestens einen gegebenenfalls substituierten Benzochinolinliganden enthält, und einem Triazin- bzw. Pyrimidinderivat, welches ein Molekulargewicht von mindestens 350 g/mol, bevorzugt mindestens 400 g/mol aufweist, wobei das Triazinderivat eine Verbindung der Formel (1) und das Pyrimidinderivat eine Verbindung der Formel (2) ist,

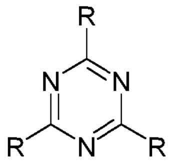

Formel (1)

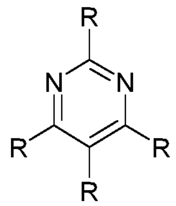

Formel (2)

wobei für die verwendeten Symbole gilt:

R ist bei jedem Auftreten gleich oder verschieden ausgewählt aus der Gruppe bestehend aus H, D, F, CN, $N(Ar)_2$, $N(R^1)_2$, C(=O)Ar, $C(=O)R^1$, $P(=O)(Ar)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^1$ substituiert sein kann, wobei eine oder mehrere nicht-benachbarte $CH_2$-Gruppen durch $R^1C=CR^1$, C=C, $Si(R^1)_2$, C=O, C=S, $C=NR^1$, $P(=O)(R^1)$, SO, $SO_2$, $NR^1$, O, S oder $CONR^1$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 80, bevorzugt 5 bis 60, aromatischen Ringatomen, das jeweils mit einem oder mehreren Resten $R^1$ substituiert sein kann, einer Aryloxy- oder Heteroaryloxygruppe mit 5 bis 60 aromatischen Ringatomen, die mit einem oder mehreren Resten $R^1$ substituiert sein kann, oder einer Aralkyl- oder Heteroaralkylgruppe mit 5 bis 60 aromatischen Ringatomen, die mit einem oder mehreren Resten $R^1$ substituiert sein kann, wobei optional zwei oder mehr benachbarte Substituenten R ein monocyclisches oder polycyclisches, aliphatisches, aromatisches oder heteroaromatisches Ringsystem bilden können, das mit einem oder mehreren Resten $R^1$ substituiert sein kann;

$R^1$ ist bei jedem Auftreten gleich oder verschieden ausgewählt aus der Gruppe bestehend aus H, D, F, Cl, Br, I, CN, $NO_2$, $N(Ar)_2$, $N(R^2)_2$, C(=O)Ar, $C(=O)R^2$, $P(=O)(Ar)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^2$ substituiert sein kann, wobei eine oder mehrere nicht-benachbarte $CH_2$-Gruppen durch $R^2C=CR^2$, $C\equiv C$, $Si(R^2)_2$, C=O, C=S, $C=NR^2$, $P(=O)(R^2)$, SO, $SO_2$, $NR^2$, O, S oder $CONR^2$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 60 aromatischen Ringatomen, das jeweils mit einem oder mehreren Resten $R^2$ substituiert sein kann, einer Aryloxy- oder Heteroaryloxygruppe mit 5 bis 60 aromatischen Ringatomen, die mit einem oder mehreren Resten $R^2$ substituiert sein kann, oder eine Aralkyl- oder Heteroaralkylgruppe mit 5 bis 60 aromatischen Ringatomen, wobei optional zwei oder mehr benachbarte Substituenten $R^1$ ein monocyclisches oder polycyclisches, aliphatisches, aromatisches oder heteroaromatisches Ringsystem bilden können, das mit einem oder mehreren Resten $R^2$ substituiert sein kann;

Ar ist bei jedem Auftreten gleich oder verschieden ein aromatisches oder heteroaromatisches Ringsystem mit 5-30 aromatischen Ringatomen, das mit einem oder mehreren nicht-aromatischen Resten $R^2$ substituiert sein kann; dabei können zwei Reste Ar, welche an dasselbe N-Atom oder P-Atom binden, auch durch eine Einfachbindung oder eine Brücke, ausgewählt aus $N(R^2)$, $C(R^2)_2$, O oder S, miteinander verbrückt sein;

$R^2$ ist ausgewählt aus der Gruppe bestehend aus H, D, F, CN, einem aliphatischem Kohlenwasserstoffrest mit 1 bis 20 C-Atomen, einem aromatischem oder heteroaromatischem Ringsystem mit 5 bis 30 aromatischen Ringatomen, in dem ein oder mehrere H-Atome durch D, F, Cl, Br, I oder CN ersetzt sein können, wobei zwei oder mehr benachbarte Substituenten $R^2$ miteinander ein mono- oder polycyclisches, aliphatisches, aromatisches oder heteroaromatisches Ringsystem bilden können;

dadurch gekennzeichnet, dass mindestens ein Rest R eine Gruppe der Formel (29) darstellt,

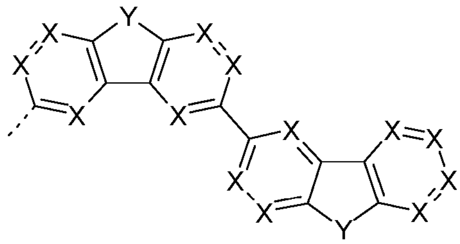

Formel (29)

wobei die gestrichelte Bindung die Bindung an die Triazineinheit in Formel (1) bzw. an die Pyrimidineinheit in Formel (2) darstellt und weiterhin gilt:

X ist bei jedem Auftreten gleich oder verschieden $CR^1$ oder N, wobei bevorzugt maximal 2 Symbole X pro Cyclus für N stehen;

Y ist bei jedem Auftreten gleich oder verschieden $C(R^1)_2$, $NR^1$, O, S oder $BR^1$, wobei $R^1$ die oben gennanten Bedeutungen aufweist.

Eine Arylgruppe im Sinne dieser Erfindung enthält 6 bis 60 C-Atome; eine Heteroarylgruppe im Sinne dieser Erfindung enthält 2 bis 60 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte (anellierte) Aryl- oder Heteroarylgruppe, beispielsweise Naphthalin, Anthracen, Phenanthren, Chinolin, Isochinolin, etc., verstanden. Miteinander durch Einfachbindung verknüpfte Aromaten, wie zum Beispiel Biphenyl, werden dagegen nicht als Aryl- oder Heteroarylgruppe, sondern als aromatisches Ringsystem bezeichnet.

Ein aromatisches Ringsystem im Sinne dieser Erfindung enthält 6 bis 80 C-Atome und keine aromatischen Heteroatome im Ringsystem. Ein heteroaromatisches Ringsystem im Sinne dieser Erfindung enthält 2 bis 60 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Dabei enthält das heteroaromatische Ringsystem ein, zwei, drei, vier oder fünf Heteroatome. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit, wie z. B. ein C-, N- oder O-Atom, verbunden sein können. So sollen beispielsweise auch Systeme wie Fluoren, 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine kurze Alkylgruppe verbunden sind.

Im Rahmen der vorliegenden Erfindung werden unter einem aliphatischen Kohlenwasserstoffrest bzw. einer Alkylgruppe bzw. einer Alkenyl- oder Alkinylgruppe, die 1 bis 40 C-Atome enthalten kann, und in der auch einzelne H-Atome oder $CH_2$-Gruppen durch die oben genannten Gruppen substituiert sein können, bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, neo-Pentyl, Cyclopentyl, n-Hexyl, neo-Hexyl, Cyclohexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl, Heptinyl oder Octinyl verstanden. Unter einer Alkoxygruppe mit 1 bis 40 C-Atomen werden bevorzugt Methoxy, Trifluormethoxy, Ethoxy, n-Propoxy, i-Propoxy, n-Butoxy, i-Butoxy, s-Butoxy, t-Butoxy, n-Pentoxy, s-Pentoxy, 2-Methylbutoxy, n-Hexoxy, Cyclohexyloxy, n-Heptoxy, Cycloheptyloxy, n-Octyloxy, Cyclooctyloxy, 2-Ethylhexyloxy, Pentafluorethoxy und 2,2,2-Trifluorethoxy verstanden. Unter einer Thioalkylgruppe mit 1 bis 40 C-Atomen werden insbesondere Methylthio, Ethylthio, n-Propylthio, i-Propylthio, n-Butylthio, i-Butylthio, s-Butylthio, t-Butylthio, n-Pentylthio, s-Pentylthio, n-Hexylthio, Cyclohexylthio, n-Heptylthio, Cycloheptylthio, n-Octylthio, Cyclooctylthio, 2-Ethylhexylthio, Trifluormethylthio, Pentafluorethylthio, 2,2,2-Trifluorethylthio, Ethenylthio, Propenylthio, Butenylthio, Pentenylthio, Cyclopentenylthio, Hexenylthio, Cyclohexenylthio, Heptenylthio, Cycloheptenylthio, Octenylthio, Cyclooctenylthio, Ethinylthio, Propinylthio, Butinylthio, Pentinylthio, Hexinylthio, Heptinylthio oder Octinylthio verstanden. Allgemein können Alkyl-, Alkoxy- oder Thioalkylgruppen gemäß der vorliegenden Erfindung geradkettig, verzweigt oder cyclisch sein, wobei eine oder mehrere nicht-benachbarte $CH_2$-Gruppen durch die oben genannten Gruppen ersetzt sein können; weiterhin können auch ein oder mehrere H-Atome durch D, F, Cl, Br, I, CN oder $NO_2$, bevorzugt F, Cl oder CN, weiter bevorzugt F oder CN, besonders bevorzugt CN ersetzt sein.

Unter einem aromatischen oder heteroaromatischen Ringsystem mit 5 - 30 bzw. 5 - 60 aromatischen Ringatomen, welches noch jeweils mit den oben genannten Resten R, $R^1$ oder $R^2$ substituiert sein kann, werden insbesondere Gruppen verstanden, die abgeleitet sind von Benzol, Naphthalin, Anthracen, Benzanthracen, Phenanthren, Pyren, Chrysen, Perylen, Fluoranthen, Naphthacen, Pentacen, Benzpyren, Biphenyl, Biphenylen, Terphenyl, Triphenylen, Fluoren, Spirobifluoren, Dihydrophenanthren, Dihydropyren, Tetrahydropyren, cis- oder trans-Indenofluoren, cis- oder trans-Indenocarbazol, cis- oder trans-Indolocarbazol, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Hexaazatriphenylen, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol oder Gruppen, die abgeleitet sind von Kombination dieser Systeme.

In Formel (1) stehen bevorzugt alle drei Substituenten R für ein aromatisches oder heteroaromatisches Ringsystem, das jeweils durch einen oder mehrere Reste $R^1$ substituiert sein kann. In Formel (2) stehen besonders bevorzugt ein, zwei oder drei Substituenten R für ein aromatisches oder heteroaromatisches Ringsystem, das jeweils durch einen oder mehrere Reste $R^1$ substituiert sein kann, und die anderen Substituenten R stehen für H. Besonders bevorzugte Ausführungsformen sind die Verbindungen der folgenden Formeln (1) bzw. (2a) bis (2d),

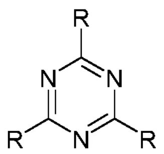
Formel (1)

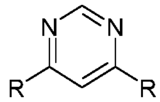
Formel (2a)

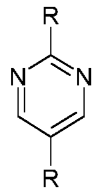
Formel (2b)

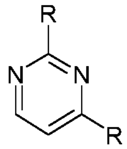
Formel (2c)

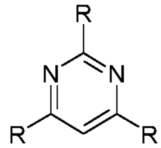
Formel (2d)

wobei R gleich oder verschieden für eine aromatisches oder heteroaromatisches Ringsystem mit 5 bis 80 aromatischen Ringatomen, bevorzugt 5 bis 60 aromatischen Ringatomen, steht, das jeweils mit einem oder mehreren Resten $R^1$ substituiert sein kann, und $R^1$ die oben genannte Bedeutung aufweist, wobei mindestens ein Rest R für eine Gruppe der Formel (29) steht.

Unter den Verbindungen der Formel (2) sind die Verbindungen der Formeln (2b) und (2d) besonders bevorzugt, insbesondere die Verbindungen der Formel (2d).

Bevorzugte aromatische oder heteroaromatische Ringsysteme enthalten 5 bis 30 aromatische Ringatome, insbesondere 6 bis 24 aromatische Ringatome, und können durch einen oder mehrere Reste $R^1$ substituiert sein. Dabei enthalten die aromatischen bzw. heteroaromatischen Ringsysteme bevorzugt keine kondensierten Aryl- bzw. Heteroarylgruppen, in denen mehr als zwei aromatische Sechsringe direkt aneinander ankondensiert sind. Besonders bevorzugt enthalten sie überhaupt keine Aryl- bzw. Heteroarylgruppen, in denen aromatische Sechsringe direkt aneinander ankondensiert sind. Diese Bevorzugung ist mit der höheren Triplettenergie derartiger Substituenten zu begründen. So ist es bevorzugt, wenn R beispielsweise keine Naphthylgruppen oder höhere kondensierte Arylgruppen aufweist und ebenso keine Chinolingruppen, Acridingruppen, etc.. Dagegen ist es möglich, dass R beispielsweise Fluorengruppen, Carbazolgruppen, Dibenzofurangruppen, etc. aufweist, weil in diesen Strukturen keine 6-Ring-Aromaten bzw. -Heteroaromaten direkt aneinander ankondensiert sind.

Bevorzugte Substituenten R sind ausgewählt aus der Gruppe bestehend aus Benzol, ortho-, meta- oder para-Biphenyl, ortho-, meta-, para- oder verzweigtem Terphenyl, ortho-, meta-, para- oder verzweigtem Quaterphenyl, 1-, 2-, 3- oder 4-Fluorenyl, 1-, 2-, 3- oder 4-Spirobifluorenyl, 1- oder 2-Naphthyl, Pyrrol, Furan, Thiophen, Indol, Benzofuran, Benzothiophen, 1-, 2- oder 3-Carbazol, 1-, 2- oder 3-Dibenzofuran, 1-, 2- oder 3-Dibenzothiophen, Indenocarbazol, Indolocarbazol, 2-, 3- oder 4-Pyridin, 2-, 4- oder 5-Pyrimidin, Pyrazin, Pyridazin, Triazin, Phenanthren, Triphenylen oder Kombinationen aus zwei oder drei dieser Gruppen, welche jeweils mit einem oder mehreren Resten $R^1$ substituiert sein können.

In bevorzugten Gruppen der Formel (29) steht maximal ein Symbol X pro Cyclus für N. Besonders bevorzugt steht das Symbol X gleich oder verschieden bei jedem Auftreten für $CR^1$, insbesondere für CH.

Bevorzugte Gruppen Y sind gleich oder verschieden bei jedem Auftreten ausgewählt aus $NR^1$, $C(R^1)_2$ oder O.

Für die Gruppen Y kommen alle Kombinationen aus der Definition von Y in Frage. Bevorzugt sind Gruppen der Formel (29), in denen eine Gruppe Y für $NR^1$ und die andere Gruppe Y für $C(R^1)_2$ steht oder in denen beide Gruppen Y für $NR^1$ stehen oder in denen beide Gruppen Y für O stehen.

In einer weiteren bevorzugten Ausführungsform der Erfindung steht mindestens eine Gruppe Y in Formel (29) gleich oder verschieden bei jedem Auftreten für $C(R^1)_2$ oder für $NR^1$.

Weiterhin bevorzugt steht in diesen Gruppen der Substituent $R^1$, der direkt an ein Stickstoffatom gebunden ist, für ein aromatisches oder heteroaromatisches Ringsystem mit 5 bis 24 aromatischen Ringatomen, welches auch durch einen oder mehrere Reste $R^2$ substituiert sein kann. In einer besonders bevorzugten Ausführungsform steht dieser Substituent $R^1$ gleich oder verschieden bei jedem Auftreten für ein aromatisches oder heteroaromatisches Ringsystem mit 6 bis 24 aromatischen Ringatomen, welches keine kondensierten Arylgruppen aufweist und welches keine kondensierten Heteroarylgruppen, in welchen zwei oder mehr aromatische bzw. heteroaromatische 6-Ring-Gruppen direkt aneinander ankondensiert sind, aufweist und welches jeweils auch durch einen oder mehrere Reste $R^2$ substituiert sein kann.

Wenn Y für $C(R^1)_2$ steht, steht $R^1$ bevorzugt gleich oder verschieden bei jedem Auftreten für eine lineare Alkylgruppe mit 1 bis 10 C-Atomen oder für eine verzweigte oder cyclische Alkylgruppe mit 3 bis 10 C-Atomen oder für ein aromatisches oder heteroaromatisches Ringsystem mit 5 bis 24 aromatischen Ringatomen, welches auch durch einen oder mehrere Reste $R^2$ substituiert sein kann. Ganz besonders bevorzugt steht $R^1$ für eine Methylgruppe oder für eine Phenylgruppe. Dabei können die beiden Gruppen $R^1$, die an dasselbe Kohlenstoffatom binden, auch miteinander einen Ring bilden und so ein Spirosystem aufspannen, welches durch einen oder mehrere Reste $R^2$ substituiert sein kann. In einer bevorzugten Ausführungsform der Erfindung stehen beide Gruppen $R^1$ für Phenylgruppen, die miteinander verknüpft sind und so ein Spirosystem aufspannen und die optional durch einen oder mehrere Reste $R^2$ substituiert sein können.

Die Gruppen R in Formel (1) bzw. (2a) bis (2d), welche nicht für eine Gruppe gemäß Formel (29) stehen, stehen bevorzugt für ein aromatisches Ringsystem mit 6 bis 24 aromatischen C-Atomen, welches mit einem oder mehreren Resten $R^1$ substituiert sein kann. Dabei weist das aromatische Ringsystem bevorzugt keine Arylgruppen auf, in denen mehr als zwei Sechsringe direkt aneinander ankondensiert sind. Besonders bevorzugt weist das aromatische Ringsystem überhaupt keine kondensierten Arylgruppen auf.

Die oben genannten Ausführungsformen können beliebig miteinander kombiniert werden. Bevorzugt treten die oben genannten Bevorzugungen gleichzeitig auf.

Beispiele für bevorzugte Verbindungen gemäß Formel (1) bzw. (2) sind die folgenden Verbindungen.

| | |
|---|---|
| 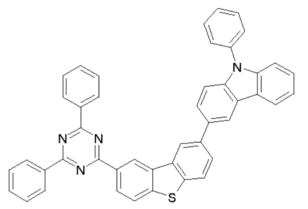 | 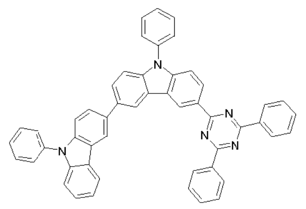 |

Im Folgenden werden bevorzugte Ausführungsformen des Iridiumkomplexes mit gegebenenfalls substituiertem Benzochinolin als Ligand beschrieben.

Bevorzugt ist der Iridiumkomplex eine Verbindung der folgenden Formel (30),

$$Ir(L)_m(L')_o \qquad \text{Formel (30)}$$

wobei $Ir(L)_m$ für eine Struktur der folgenden Formel (31) steht,

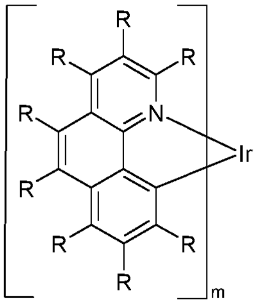

Formel (31)

wobei R die oben genannten Bedeutungen aufweist, jedoch benachbarte Reste R kein aromatisches Ringsystem bilden können, und weiterhin gilt:

L' ist gleich oder verschieden bei jedem Auftreten ein bidentater monoanionischer Ligand;

m ist 1, 2 oder 3;

o ist 3 - m.

In einer bevorzugten Ausführungsform der Erfindung ist die Einheit der Formel $M(L)_m$ ausgewählt aus den Strukturen der folgenden Formel (31a),

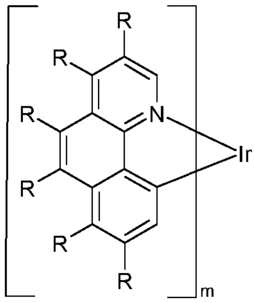

Formel (31a)

wobei die verwendeten Symbole und Indizes die oben genannten Bedeutungen aufweisen.

In einer weiteren bevorzugten Ausführungsform der Erfindung ist m = 2 oder 3 und o ist entsprechend = 1 oder 0. Besonders bevorzugt ist m = 3 und o = 0.

Bevorzugte Substituenten R in Strukturen der Formel (31) bzw. (31a) sind gleich oder verschieden bei jedem Auftreten ausgewählt aus der Gruppe bestehend aus H, D, F, CN, $N(Ar)_2$, $N(R^1)_2$, C(=O)Ar, einer geradkettigen Alkyl- oder Alkoxygruppe mit 1 bis 10 C-Atomen oder einer verzweigten oder cyclischen Alkyl- oder Alkoxygruppe mit 3 bis 10 C-Atomen oder einer Alkenylgruppe mit 2 bis 10 C-Atomen, die jeweils mit einem oder mehreren Resten $R^1$ substituiert sein kann, wobei eine oder mehrere nicht-benachbarte $CH_2$-Gruppen durch $R^1C=CR^1$ oder O ersetzt sein können und wobei ein oder mehrere H-Atome durch D oder F ersetzt sein können, einem aromatischen oder heteroaromatischen Ringsystem mit 5 bis 24 aromatischen Ringatomen, das jeweils mit einem oder mehreren Resten $R^1$ substituiert sein kann, einer Aryloxy- oder Heteroaryloxygruppe mit 5 bis 24 aromatischen Ringatomen, die mit einem oder mehreren Resten $R^1$ substituiert sein kann, oder einer Aralkyl- oder Heteroaralkylgruppe mit 5 bis 24 aromatischen Ringatomen, die mit einem oder mehreren Resten $R^1$ substituiert sein kann, wobei optional zwei oder mehr benachbarte Substituenten R ein monocyclisches oder polycyclisches, aliphatisches Ringsystem bilden können, das mit einem oder mehreren Resten $R^1$ substituiert sein kann.

Besonders bevorzugte Substituenten R in Strukturen der Formel (31) bzw. (31a) sind gleich oder verschieden bei jedem Auftreten ausgewählt aus der Gruppe bestehend aus H, F, CN, einer geradkettigen Alkylgruppe mit 1 bis 6 C-Atomen oder einer verzweigten oder cyclischen Alkylgruppe mit 3 bis 6 C-Atomen, die jeweils mit einem oder mehreren Resten $R^1$ substituiert sein kann, oder einem aromatischen oder heteroaromatischen Ringsystem mit 5 bis 14 aromatischen Ringatomen, das jeweils mit einem oder mehreren Resten $R^1$ substituiert sein kann, wobei optional zwei oder mehr benachbarte Substituenten R ein monocyclisches oder polycyclisches, aliphatisches Ringsystem bilden können, das mit einem oder mehreren Resten $R^1$ substituiert sein kann.

Dabei ist es bevorzugt, wenn im Liganden L maximal drei Substituenten R, besonders bevorzugt maximal zwei Substituenten R, ganz besonders bevorzugt maximal ein Substituent R ungleich Wasserstoff ist. Insbesondere bevorzugt

stehen alle Substituenten R für H.

Wie oben definiert, sind die Liganden L' bidentate, monoanionische Liganden. Bevorzugte Liganden L' sind ausgewählt aus 1,3-Diketonaten abgeleitet von 1,3-Diketonen, wie z. B. Acetylaceton, Benzoylaceton, 1,5-Diphenylacetylaceton, Dibenzoylmethan, Bis(1,1,1-trifluoracetyl)-methan, 2,2,6,6-Tetramethyl-3,5-heptandion, 3-Ketonaten abgeleitet von 3-Ketoestern, wie z. B. Acetessigsäureethylester, Carboxylaten, abgeleitet von Aminocarbonsäuren, wie z. B. Pyridin-2-carbonsäure, Chinolin-2-carbonsäure, Glycin, N,N-Dimethylglycin, Alanin, N,N-Dimethylamino-alanin, und Salicyliminaten abgeleitet von Salicyliminen, wie z. B. Methylsalicylimin, Ethylsalicylimin, Phenylsalicylimin.

Bevorzugt sind weiterhin bidentate monoanionische Liganden L', welche mit dem Metall einen cyclometallierten Fünfring oder Sechsring mit mindestens einer Metall-Kohlenstoff-Bindung bilden, insbesondere einen cyclometallierten Fünfring. Dies sind insbesondere Liganden, wie sie allgemein im Gebiet der phosphoreszierenden Metallkomplexe für organische Elektrolumineszenzvorrichtungen verwendet werden, also Liganden vom Typ Phenylpyridin, Naphthylpyridin, Phenylchinolin, Phenylisochinolin, etc., welche jeweils durch einen oder mehrere Reste R substituiert sein können. Dem Fachmann auf dem Gebiet der phosphoreszierenden Elektrolumineszenzvorrichtungen ist eine Vielzahl derartiger Liganden bekannt, und er kann ohne erfinderisches Zutun weitere derartige Liganden als Ligand L' für Verbindungen gemäß Formel (30) auswählen. Generell eignet sich dafür besonders die Kombination aus zwei Gruppen, wie sie durch die folgenden Formeln (32) bis (59) dargestellt sind, wobei eine Gruppe über ein neutrales Stickstoffatom oder ein Carbenatom bindet und die andere Gruppe über ein negativ geladenes Kohlenstoffatom oder ein negativ geladenes Stickstoffatom bindet. Der Ligand L' kann dann aus den Gruppen der Formeln (32) bis (59) gebildet werden, indem diese Gruppen jeweils an der durch # gekennzeichneten Position aneinander binden. Die Position, an der die Gruppen an das Metall koordinieren, sind durch * gekennzeichnet.

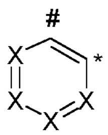
Formel (32)

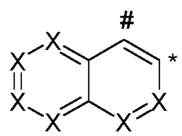
Formel (33)

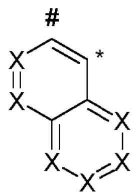
Formel (34)

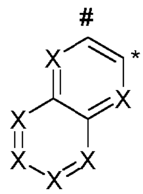
Formel (35)

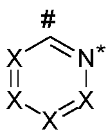
Formel (36)

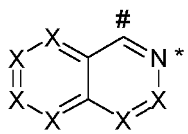
Formel (37)

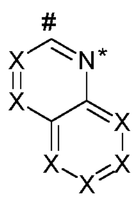
Formel (38)

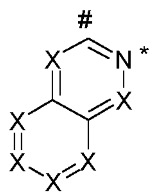
Formel (39)

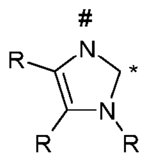
Formel (40)

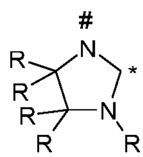
Formel (41)

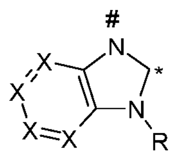
Formel (42)

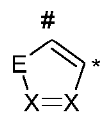
Formel (43)

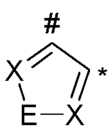
Formel (44)

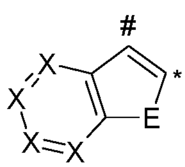
Formel (45)

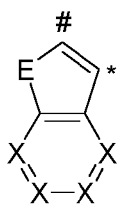
Formel (46)

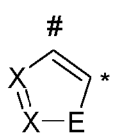
Formel (47)

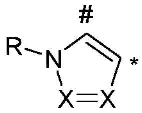
Formel (48)

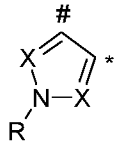
Formel (49)

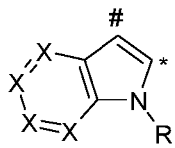
Formel (50)

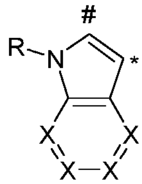
Formel (51)

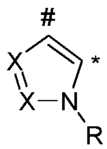
Formel (52)

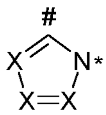
Formel (53)

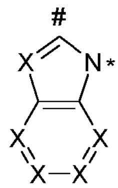
Formel (54)

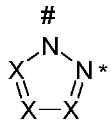
Formel (55)

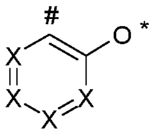
Formel (56)

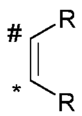
Formel (57)

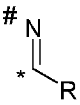
Formel (58)

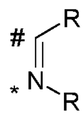
Formel (59).

Dabei haben die verwendeten Symbole dieselbe Bedeutung wie oben beschrieben, und bevorzugt stehen maximal drei Symbole X in jeder Gruppe für N, besonders bevorzugt stehen maximal zwei Symbole X in jeder Gruppe für N, ganz besonders bevorzugt steht maximal ein Symbol X in jeder Gruppe für N. Insbesondere bevorzugt stehen alle Symbole X für CR.

Bevorzugte Reste R in den oben aufgeführten Strukturen der Formeln (32) bis (59), welche als Substituenten an X vorhanden sind, sind die gleichen Substituenten, wie sie oben als bevorzugte Reste R am Liganden L beschrieben sind.

Die Komplexe der Formel (30) können facial bzw. pseudofacial sein, oder sie können meridional bzw. pseudomeridional sein.

Die oben genannten Ausführungsformen können beliebig miteinander kombiniert werden. Bevorzugt treten die oben genannten Bevorzugungen gleichzeitig auf.

Geeignete Iridiumkomplexe der Formel $Ir(L)_m(L')_o$ sind in der folgenden Tabelle aufgeführt.

| | | |
|---|---|---|
| 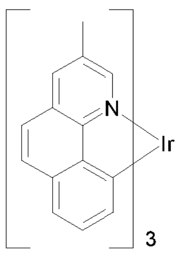 | 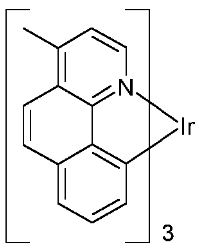 | 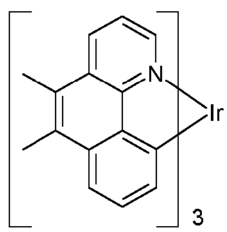 |
| 1 | 2 | 3 |

(fortgesetzt)

| | | |
|---|---|---|
| 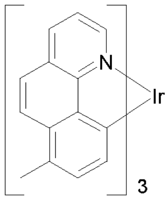 | 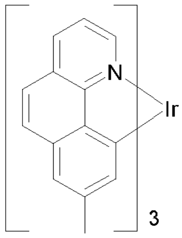 | 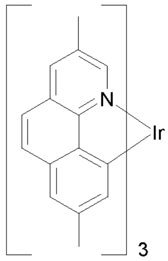 |
| 4 | 5 | 6 |
| 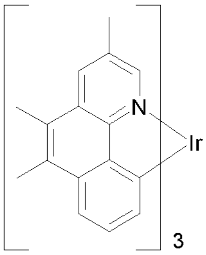 | 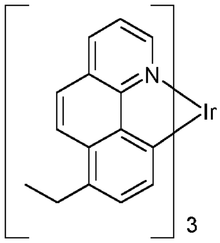 | 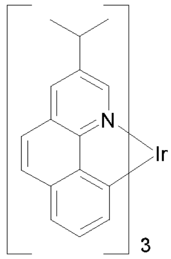 |
| 7 | 8 | 8 |
| 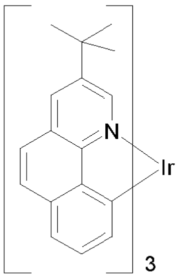 | 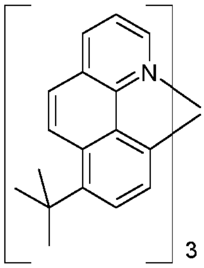 | 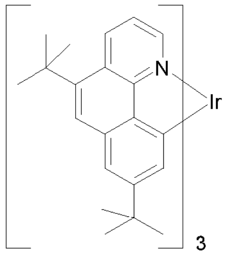 |
| 10 | 11 | 12 |
| 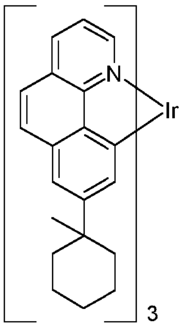 | 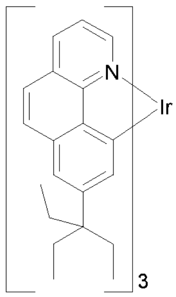 | 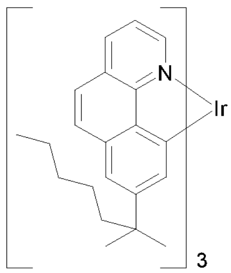 |
| 13 | 14 | 15 |
| 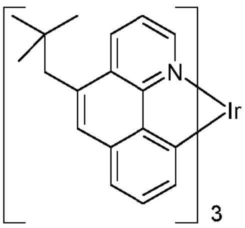 | 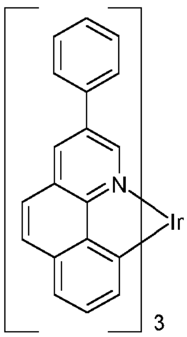 | 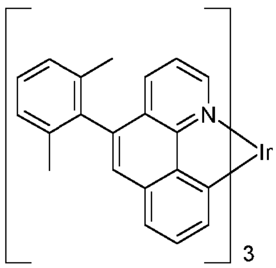 |

(fortgesetzt)

| 16 | 17 | 18 |
|---|---|---|
| 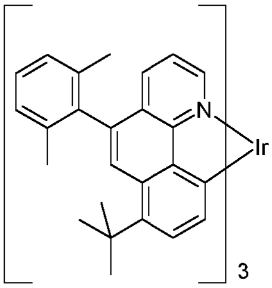 | 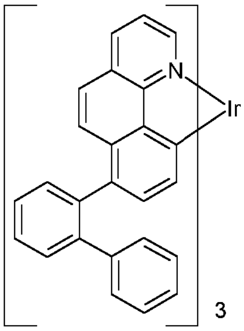 | 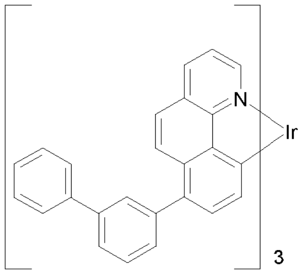 |
| 19 | 20 | 21 |
| 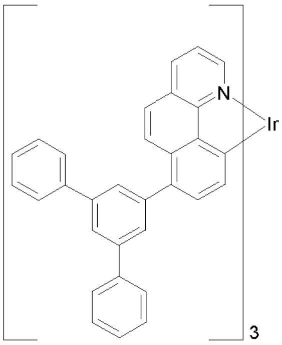 | 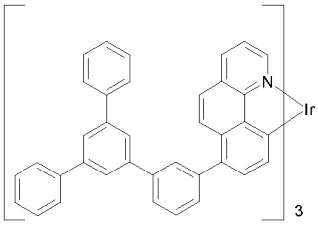 | 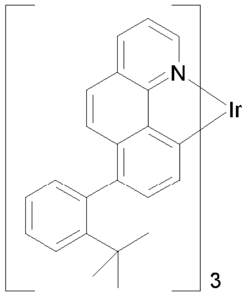 |
| 22 | 23 | 24 |
| 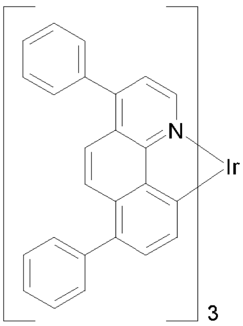 | 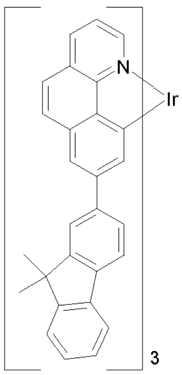 | 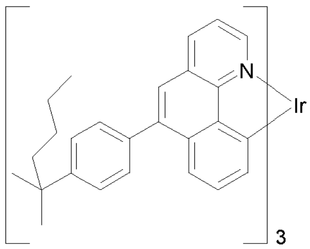 |
| 25 | 26 | 27 |
| 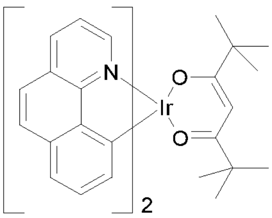 | 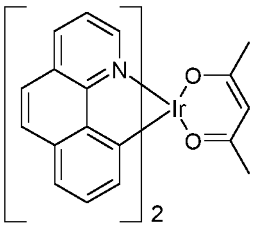 | 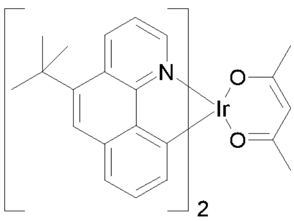 |
| 28 | 29 | 30 |

(fortgesetzt)

| | | |
|---|---|---|
| 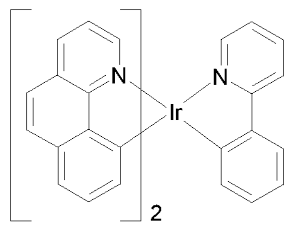 | 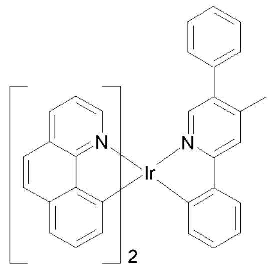 | 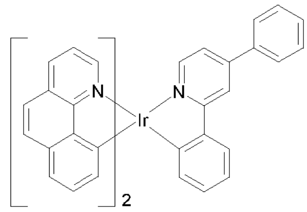 |
| 31 | 32 | 33 |
| 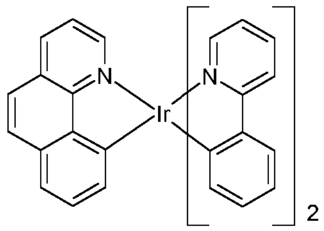 | 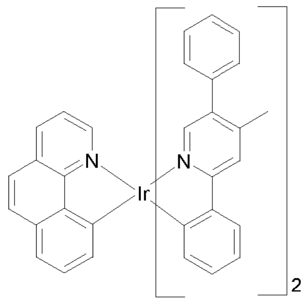 | 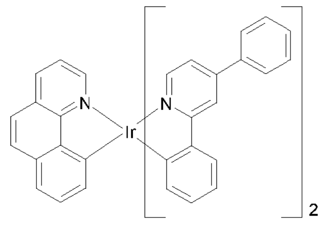 |
| 34 | 35 | 36 |

Die oben genannten bevorzugten Ausführungsformen sind beliebig miteinander kombinierbar. In einer besonders bevorzugten Ausführungsform der Erfindung gelten die oben genannten bevorzugten Ausführungsformen gleichzeitig. Insbesondere enthält also die bevorzugte organische Elektrolumineszenzvorrichtung mindestens eines der oben aufgeführten bevorzugten Triazin- bzw. Pyrimidinderivate und mindestens einen der oben aufgeführten bevorzugten Iridiumkomplexe der Formel (30) bzw. der nochmals bevorzugten Iridiumkomplexe.

Die erfindungsgemäße organische Elektrolumineszenzvorrichtung enthält zwischen 1 und 99 Vol.-%, vorzugsweise zwischen 2 und 90 Vol.-%, besonders bevorzugt zwischen 3 und 40 Vol.-%, insbesondere zwischen 5 und 15 Vol.-% des Iridiumkomplexes, bezogen auf die Gesamtmischung aus Emitter und Matrixmaterial. Entsprechend enthält die Mischung zwischen 99 und 1 Vol.-%, vorzugsweise zwischen 98 und 10 Vol.-%, besonders bevorzugt zwischen 97 und 60 Vol.-%, insbesondere zwischen 95 und 85 Vol.-% des Triazin- bzw. Pyrimidinderivats der Formel (1) bzw. (2), bezogen auf die Gesamtmischung aus Emitter und Matrixmaterial.

Die erfindungsgemäße organische Elektrolumineszenzvorrichtung enthält bevorzugt Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten und/oder Ladungserzeugungsschichten (Charge-Generation Layers). Ebenso können zwischen zwei emittierende Schichten Interlayer eingebracht sein, welche beispielsweise eine exzitonenblockierende Funktion aufweisen. Es sei aber darauf hingewiesen, dass nicht notwendigerweise jede dieser Schichten vorhanden sein muss.

Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Eine bevorzugte Ausführungsform sind Zweischichtsysteme, wobei die beiden Schichten blaue und gelbe Emission zeigen. Solche Systeme sind vor allem deshalb bevorzugt, da die emittierende Schicht gemäß der vorliegenden Erfindung besonders gute Eigenschaften bei gelber Emission zeigt. Zweischichtsysteme sind insbesondere für Beleuchtungsanwendungen von Interesse. Die weiß emittierenden Elektrolumineszenzvorrichtungen können aber auch als Backlight für Displays oder mit Farbfilter als Display eingesetzt werden. Eine weitere bevorzugte Ausführungsform sind Dreischichtsysteme, wobei die drei Schichten blaue, gelbe und rote Emission zeigen.

In einer bevorzugten Ausführungsform der Erfindung enthält die organische Elektrolumineszenzvorrichtung außer dem Triazin- bzw. Pyrimidinderivat noch mindestens ein weiteres Matrixmaterial. Hierfür können generell alle Materialien eingesetzt werden, die gemäß dem Stand der Technik als Triplett-Matrixmaterialien bekannt sind. Bevorzugt ist das Triplett-Niveau des Matrixmaterials verlgeichbar oder höher als das Triplett-Niveau des Emitters. Dabei kann

das weitere Matrixmaterial elektronentransportierende Eigenschaften oder lochtransportierende Eigenschaften aufweisen, oder es kann sich um ein Material mit einer großen Bandlücke handeln, welches weitgehend elektrisch inert ist und nicht oder nicht in wesentlichem Umfang am Ladungstransport teilnimmt, wie z. B. in WO 2010/108579 beschrieben.

Geeignete weitere Matrixmaterialien, die in der erfindungsgemäßen organischen Elektrolumineszenzvorrichtung zusammen mit dem Triazin- bzw. Pyrimidinderivat der Formel (1) bzw. (2) eingesetzt werden können, sind Ketone, Phosphinoxide, Sulfoxide und Sulfone, z. B. gemäß WO 2004/013080, WO 2004/093207, WO 2006/005627 oder WO 2010/006680, Triarylamine, Carbazolderivate, z. B. CBP (N,N-Biscarbazolylbiphenyl), m-CBP oder die in WO 2005/039246, US 2005/0069729, JP 2004/288381, EP 1205527, WO 2008/086851 oder US 2009/0134784 offenbarten Carbazolderivate, Indolocarbazolderivate, z. B. gemäß WO 2007/063754 oder WO 2008/056746, Indenocarbazolderivate, z. B. gemäß WO 2010/136109 oder WO 2011/000455, Azacarbazole, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Diazasilolderivate, z. B. gemäß WO 2010/054729, Diazaphospholderivate, z. B. gemäß WO 2010/054730, Triazinderivate, z. B. gemäß WO 2010/015306, WO 2007/063754 oder WO 2008/056746, Zinkkomplexe, z. B. gemäß EP 652273 oder WO 2009/062578, Dibenzofuranderivate, z. B. gemäß WO 2009/148015, verbrückte Carbazolderivate, z. B. gemäß US 2009/0136779, WO 2010/050778, WO 2011/042107 oder WO 2011/088877 oder Lactame, z. B. gemäß WO 2011/116865, WO 2011/137951, WO 2013/064206 oder der nicht offen gelegten Anmeldung EP 12007040.4. Auch ein kürzerwellig emittierender anderer Triplettemitter, beispielsweise ein grün oder blau emittierender Iridium- oder Platinkomplex, kann als weiteres Matrixmaterial zusammen mit dem Triazin- bzw. Pyrimidinderivat in der organischen Elektrolumineszenzvorrichtung eingesetzt werden. Dieser dient als Co-Matrix für den Iridiumkomplex mit dem Benzochinolinliganden.

Weiterhin bevorzugt ist es, wenn die erfindungsgemäße organische Elektrolumineszenzvorrichtung außer dem Iridiumkomplex mit dem Benzochinolinliganden einen weiteren Triplett-Emitter enthält, der längerwellig emittiert. Dabei dient der Iridiumkomplex mit dem Benzochinolinliganden als Co-Matrix für den Triplett-Emitter mit dem längerwelligen Emissionsspektrum.

In einer weiteren Ausführungsform der Erfindung enthält die erfindungsgemäße organische Elektrolumineszenzvorrichtung keine separate Lochinjektionsschicht und/oder Lochtransportschicht und/oder Lochblockierschicht und/oder Elektronentransportschicht, d. h. die emittierende Schicht grenzt direkt an die Lochinjektionschicht oder die Anode an, und/ oder die emittierende Schicht grenzt direkt an die Elektronentransportschicht oder die Elektroneninjektionsschicht oder die Kathode an, wie zum Beispiel in WO 2005/053051 beschrieben.

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lathanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, $Li_2O$, $BaF_2$, MgO, NaF, CsF, $Cs_2CO_3$, etc.). Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektronen (z. B. Al/Ni/$NiO_x$, Al/$PtO_x$) bevorzugt sein. Für einige Anwendungen muss mindestens eine der Elektroden transparent sein, um entweder die Bestrahlung des organischen Materials (O-SC) oder die Auskopplung von Licht (OLED/PLED, O-LASER) zu ermöglichen. Ein bevorzugter Aufbau verwendet eine transparente Anode. Bevorzugte Anodenmaterialien sind hier leitfähige gemischte Metalloxide. Besonders bevorzugt sind Indium-Zinn-Oxid (ITO) oder Indium-Zink Oxid (IZO). Bevorzugt sind weiterhin leitfähige, dotierte organische Materialien, insbesondere leitfähige dotierte Polymere.

In den weiteren Schichten der erfindungsgemäßen organischen Elektrolumineszenzvorrichtung, insbesondere in den Lochinjektions- und -transportschichten und in den Elektroneninjektions- und -transportschichten, können alle Materialien verwendet werden, wie sie üblicherweise gemäß dem Stand der Technik eingesetzt werden. Der Fachmann kann daher ohne erfinderisches Zutun alle für organische Elektrolumineszenzvorrichtungen bekannten Materialien in Kombination mit der erfindungsgemäßen emittierenden Schicht einsetzen.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck kleiner $10^{-5}$ mbar, bevorzugt kleiner $10^{-6}$ mbar aufgedampft. Es ist aber

auch möglich, dass der Anfangsdruck noch geringer ist, beispielsweise kleiner $10^{-7}$ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen $10^{-5}$ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Offsetdruck, LITI (Light Induced Thermal Imaging, Thermotransferdruck), Ink-Jet Druck (Tintenstrahldruck) oder Nozzle Printing, hergestellt werden. Hierfür sind lösliche Verbindungen nötig, welche beispielsweise durch geeignete Substitution erhalten werden. Diese Verfahren eignen sich insbesondere auch für Oligomere, Dendrimere und Polymere.

Weiterhin sind Hybridverfahren möglich, bei denen beispielsweise eine oder mehrere Schichten aus Lösung aufgebracht werden und eine oder mehrere weitere Schichten aufgedampft werden.

Diese Verfahren sind dem Fachmann generell bekannt und können von ihm ohne erfinderisches Zutun auf organische Elektrolumineszenzvorrichtungen enthaltend die erfindungsgemäßen Verbindungen angewandt werden.

Ein weiterer Gegenstand der vorliegenden Erfindung ist daher ein Verfahren zur Herstellung einer erfindungsgemäßen organischen Elektrolumineszenzvorrichtung, dadurch gekennzeichnet, dass mindestens eine Schicht mit einem Sublimationsverfahren aufgebracht wird und/oder dass mindestens eine Schicht mit einem OVPD (Organic Vapour Phase Deposition) Verfahren oder mit Hilfe einer Trägergassublimation aufgebracht wird und/oder dass mindestens eine Schicht aus Lösung, durch Spincoating oder mit einem Druckverfahren aufgebracht wird.

Nochmals ein weiterer Gegenstand der vorliegenden Erfindung ist eine Mischung, enthaltend mindestens einen Iridiumkomplex, welcher mindestens einen gegebenenfalls substituierten Benzochinolinliganden enthält, und mindestens ein Triazin- bzw. Pyrimidinderivat der Formel (1) oder Formel (2), wie oben beschrieben, welches ein Molekulargewicht von mindestens 350 g/mol, bevorzugt mindestens 400 g/mol aufweist. Dabei gelten für die Komponenten der erfindungsgemäßen Mischungen dieselben Bevorzugungen, wie oben für die organischen Elektrolumineszenzvorrichtungen ausgeführt.

Für die Verarbeitung der erfindungsgemäßen Mischungen aus flüssiger Phase sind Formulierungen der erfindungsgemäßen Mischungen erforderlich. Diese Formulierungen können beispielsweise Lösungen, Dispersionen oder Emulsionen sein. Es kann bevorzugt sein, hierfür Mischungen aus zwei oder mehr Lösemitteln zu verwenden. Geeignete und bevorzugte Lösemittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, $\alpha$-Terpineol, Benzothiazol, Butylbenzoat, Cumol, Cyclohexanol, Cyclohexanon, Cyclohexylbenzol, Decalin, Dodecylbenzol, Ethylbenzoat, Indan, Methylbenzoat, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylenglycolmonobutylether, Tripropyleneglycoldimethylether, Tetraethylenglycoldimethylether, 2-Isopropylnaphthalin, Pentylbenzol, Hexylbenzol, Heptylbenzol, Octylbenzol, 1,1-Bis(3,4-dimethylphenyl)ethan oder Mischungen dieser Lösemittel. Wie solche Lösungen hergestellt werden können, ist dem Fachmann bekannt und beispielsweise in der WO 2002/072714, der WO 2003/019694 und der darin zitierten Literatur beschrieben.

Ein weiterer Gegenstand der vorliegenden Erfindung ist daher eine Formulierung, enthaltend eine erfindungsgemäße Mischung und mindestens ein Lösemittel, insbesondere eines der oben genannten Lösemittel oder eine Mischung dieser Lösemittel.

Die erfindungsgemäßen organischen Elektrolumineszenzvorrichtungen zeichnen sich gegenüber dem Stand der Technik durch eine überraschend hohe, exzellente Lebensdauer aus. Dieser Vorteil geht nicht mit einer Verschlechterung der anderen elektronischen Eigenschaften einher. Die erfindungsgemäßen organischen Elektrolumineszenzvorrichtungen eignen sich daher hervorragend nicht nur für gelb emittierende Vorrichtungen, sondern insbesondere auch für weiß emittierende Vorrichtungen.

Die Erfindung wird durch die nachfolgenden Beispiele näher erläutert, ohne sie dadurch einschränken zu wollen. Der Fachmann kann aus den Schilderungen die Erfindung im gesamten offenbarten Bereich ausführen und ohne erfinderisches Zutun weitere erfindungsgemäße organische Elektrolumineszenzvorrichtungen herstellen.

**Beispiele:**

**Synthese der Iridiumkomplexe mit Benzochinolinliganden**

Die nachfolgenden Synthesen werden, sofern nicht anders angegeben, unter einer Schutzgasatmosphäre in

getrockneten Lösungsmitteln durchgeführt. Die Metallkomplexe werden zusätzlich unter Ausschluss von Licht bzw. unter Gelblicht gehandhabt. Die Lösungsmittel und Reagenzien können z. B. von Sigma-ALDRICH bzw. ABCR bezogen werden. Die jeweiligen Angaben in eckigen Klammern bzw. die zu einzelnen Verbindungen angegebenen Nummern beziehen sich auf die CAS-Nummern der literaturbekannten Verbindungen.

**Beispiel 1: fac-Tris(benzo[*h*]chinolin-10-yl-κ*C*,κ*N*)-iridium, [337526-98-4]**

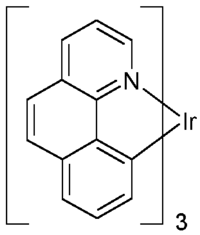

50 g (103 mmol) Natrium[bis-acetylacetonato-dichloro]iridat(III) [770720-50-8] und 148 g (825 mmol) Benzo(h)chinolin [230-27-3] werden in 600 ml 1,2-Propylenglycol suspendiert und 4 Tage unter Rückfluss erhitzt, wobei ein orangefarbener Feststoff ausfällt. Dann wird abgekühlt und mit 2 L Ethanol und 400 ml 1 N Salzsäure versetzt. Der Feststoff wird abgesaugt, 5 x mit je 500 ml einer 1:1 Mischung aus 1 N HCl und Ethanol und 5 x mit je 500 ml einer 1:1 Mischung aus Ethanol / Wasser gewaschen. Das Produkt wird getrocknet und mit Chlorbenzol über 3 Tage soxhletiert. Dann wird das Produkt bei 320 °C im Hochvakuum (p ca. $10^{-5}$ mbar) fraktioniert sublimiert. Man erhält 32 g (44 mmol) 43 % des Produktes als orangefarbenen Feststoff. Reinheit: > 99.5 % n. HPLC.

Analog können folgende Verbindungen dargestellt werden:

| Bsp. | Benzo-[h]chinolin | Produkt | Ausbeute |
|---|---|---|---|
| 2 | 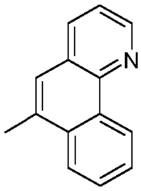 31485-96-8 | 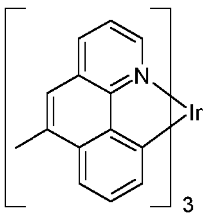 | 44 % |
| 3 | 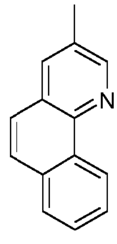 37062-82-1 | 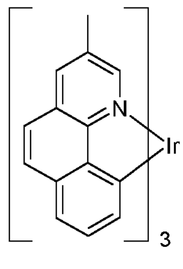 | 41 % |
| 4 | 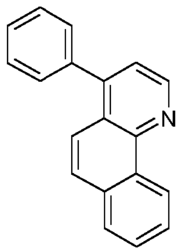 31493-10-4 | 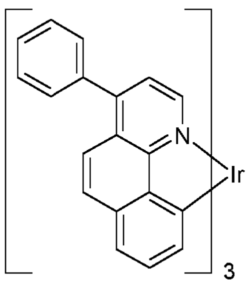 | 37 % |

(fortgesetzt)

| Bsp. | Benzo-[h]chinolin | Produkt | Ausbeute |
|---|---|---|---|
| 5 | 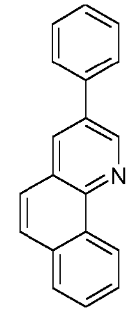 50781-37-8 | 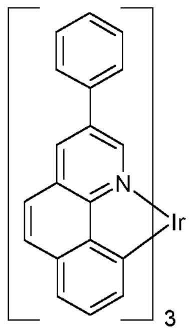 | 39 % |

**Beispiel 6: fac-Bis(benzo[*h*]chinolin-10-yl-κ*C*,κ*N*)(2-(3-tert-butyl-phen-1-yl-pyridin-κ*C*,κ*N*)-iridium**

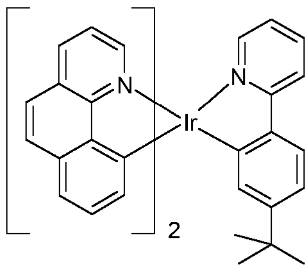

Darstellung analog zu Beispiel 1 wobei anstatt Natrium[bis-acetyl-acetonato-dichloro]iridat(III) 64.8 g (100 mmol) Bis(benzo[h]chinolin-10-yl-κ**C**,κ**N**)(2,4-pentandionato-κ**O**$^2$,κ**O**$^4$)-iridium [337526-87-1] und anstelle von Benzo(h)chinolin 23.3 g (110 mmol) 2-[4-(1,1-Dimethylethyl)phenyl-pyridin [524713-66-4] eingesetzt werden. Das soxhletierte Rohprodukt wird chromatographisch (Kieselgel, Dichlormethan) gereinigt und bei 300 °C im Hochvakuum (p ca. $10^{-5}$ mbar) fraktioniert sublimiert. Man erhält 28.8 g (38 mmol), 38 % des Produktes als orangefarbenen Feststoff. Reinheit: > 99.5 % n. HPLC.

Analog können folgende Verbindungen dargestellt werden:

| Bsp. | Ligand | Produkt | Ausbeute |
|---|---|---|---|
| 7 | 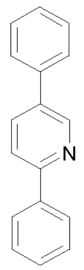 15827-72-2 | 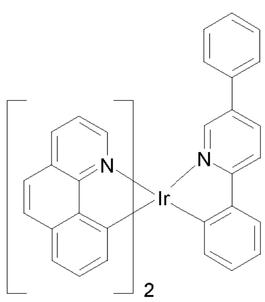 | 33 % |

(fortgesetzt)

| Bsp. | Ligand | Produkt | Ausbeute |
|---|---|---|---|
| 8 | 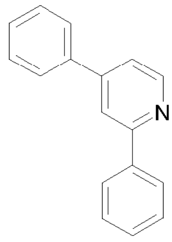 26274-35-1 | 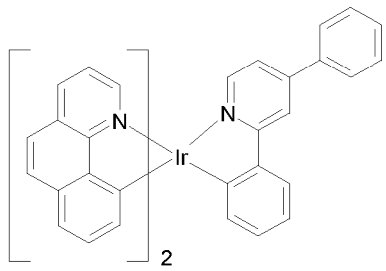 | 35 % |
| 9 | 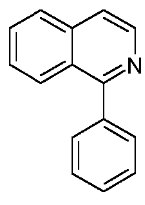 3297-72-1 | 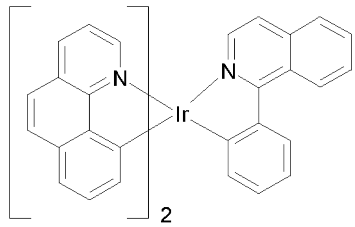 | 29 % |

**Herstellung der OLEDs**

In den folgenden Beispielen (siehe Tabellen 1 und 2) werden die Daten verschiedener OLEDs vorgestellt.

Glasplättchen, die mit strukturiertem ITO (Indium Zinn Oxid) der Dicke 50 nm beschichtet sind, bilden die Substrate für die OLEDs. Die Substrate werden nass gereinigt (Spülmaschine, Reiniger Merck Extran), anschließend 15 min. bei 250 °C ausgeheizt und vor der Beschichtung mit einem Sauerstoffplasma behandelt.

Die OLEDs haben prinzipiell folgenden Schichtaufbau: Substrat / Lochinjektionsschicht (HIL) / Lochtransportschicht (HTL) / Elektronenblockerschicht (EBL) / Emissionsschicht (EML) / Elektronentransportschicht (ETL) / optionale Elektroneninjektionsschicht (EIL) und abschließend eine Kathode. Die Kathode wird durch eine 100 nm dicke Aluminiumschicht gebildet. Der genaue Aufbau der OLEDs ist Tabelle 1 zu entnehmen. Die zur Herstellung der OLEDs benötigten Materialien sind in Tabellle 3 gezeigt.

Alle Materialien werden in einer Vakuumkammer thermisch aufgedampft. Dabei besteht die Emissionsschicht immer aus einem oder zwei Matrixmaterialien und einem emittierenden Material als Dotand. Dieser wird dem/den Matrixmaterial/ien durch Coverdampfung in einem bestimmten Volumenanteil beigemischt. Eine Angabe wie H1:YD1 (95%:5%) bedeutet hierbei, dass das Material H1 in einem Volumenanteil von 95% und YD1 in einem Anteil von 5% in der Schicht vorliegt. Analog können auch andere Schichten aus einer Mischung von Materialien bestehen.

Die OLEDs werden standardmäßig charakterisiert. Hierfür werden die Elektrolumineszenzspektren, die Stromeffizienz (gemessen in cd/A), die Leistungseffizienz (gemessen in lm/W) und die externe Quanteneffizienz (EQE, gemessen in Prozent) in Abhängigkeit der Leuchtdichte, berechnet aus Strom-Spannungs-Leuchtdichte-Kennlinien (IUL-Kennlinien) unter Annahme einer lambertschen Abstrahlcharakteristik sowie die Lebensdauer bestimmt. Die Elektrolumineszenzspektren werden bei einer Leuchtdichte von 1000 cd/$m^2$ bestimmt und daraus die CIE 1931 x und y Farbkoordinaten berechnet. Die Angabe U1000 in Tabelle 2 bezeichnet die Spannung, die für eine Leuchtdichte von 1000 cd/$m^2$ benötigt wird. SE1000 und LE1000 bezeichnen die Strom- bzw. Leistungseffizienz, die bei 1000 cd/$m^2$ erreicht werden. EQE1000 schließlich bezeichnet die externe Quanteneffizienz bei einer Betriebsleuchtdichte von 1000 cd/$m^2$.

Als Lebensdauer LD wird die Zeit definiert, nach der die Leuchtdichte bei Betrieb mit konstantem Strom von der Startleuchtdichte 1000 cd/$m^2$ auf 500 cd/$m^2$ abgesunken ist. Die reale Messung erfolgt dabei bei konstant gehaltenem Strom von 50 mA/$cm^2$ und damit bei einer je nach OLED gegebenen, im Allgemeinen höheren, Startleuchtdichte S. Es wird dann die Zeit T ermittelt, nach der die Helligkeit auf die Hälfte von S abgefallen ist. Die angegebene LD bei Startleuchtdichte 1000 cd/$m^2$ wird dann mit dem Beschleunigungsexponenten 1.6 über folgende Formel erhalten, was einer gängigen Praxis zur Ermittlung der Lebensdauer von OLEDs über eine beschleunigte Messung entspricht.

$$LD = T * (S / 1000 cd/m^2) ^ {1.6}$$

Die Daten der verschiedenen OLEDs sind in Tabelle 2 zusammengefasst. Die mit V bezeichneten Beispiele sind Vergleichsbeispiele gemäß dem Stand der Technik, die mit E bezeichneten Beispiele zeigen Daten von erfindungsgemäßen OLEDs.

Im Folgenden werden einige der Beispiele näher erläutert, um die Vorteile der erfindungsgemäßen Verbindungen zu verdeutlichen. Es sei jedoch darauf hingewiesen, dass dies nur eine Auswahl der in Tabelle 2 gezeigten Daten darstellt.

Beispiele E1 bis E11 (E1, E2, E4-E11 nicht erfindungsgemäß) zeigen OLEDs, bei denen der Emitter YD1 gemischt wird mit je einem Matrixmaterial H1 bis H9 oder ST2. Alle OLEDs zeigen hervorragende Emissionscharakteristik mit gelber Farbe, Leistungseffizienzen zwischen 70 und 100 lm/W, EQEs typischerweise >20% und vor allem exzellente Betriebslebensdauern LT50 bei 1000 cd/$m^2$ Starthelligkeit im Bereich 200 000 bis 350 000 h.

Vergleichsbeispiele V1 bis V3 verwenden denselben Emitter YD1, in diesem Fall allerdings nicht erfindungsgemäß gemischt mit den Matrixmaterialien CH2, SK oder CBP. Die Leistungsdaten zeigen einen deutlichen Abfall im Vergleich zu den Beispielen E1-E11.

Die Vergleichsbeispiele V4 bis V8 zeigen analog einen Vergleich zwischen H1 bzw. H2 und CH2, SK und CBP, in diesem Fall als nicht erfindungsgemäße Mischung mit dem Emitter Irppy. Abgesehen davon, dass die Emissionsdaten, insbesondere die Betriebslebensdauer mit maximal 66000 h auf einem deutlich niedrigeren Level liegt als mit YD1, zeigt der Vergleich H1 bzw. H2 einerseits mit CH2, SK und CBP andererseits, dass der Vorteil von H1 bzw. H2 (siehe V4 bzw. V5) gegenüber den anderen Matrixmaterialien (siehe V6 bis V8) nicht so groß ist, wie er im Fall von YD1 (E1, E2 gegen V1 bis V3) ist. Dies illustriert deutlich, dass der Vorteil der Erfindung gerade in der Kombination aus dem Emitter YD1 mit einem der Matrixmaterialien H1 bis H8 (H1, H2, H4-H8 nicht erfindungsgemäß) liegt und sich nicht schlicht durch Addition der Leistungsvorteile des Emitters bzw. der Matrixmaterialien als solches erklären lässt.

Die weiteren Beispiele zeigen weitere möglich Ausführungsformen der Erfindung.

E12 und E13 (nicht erfindungsgemäß) enthalten neben der Mischung aus Emitter und Hostmaterial noch ein zweites Hostmaterial, d. h. es handelt sich um Bauteile mit gemischter Matrix. Auch diese zeigen hervorragende Emissionsdaten. Die Betriebslebensdauer von E13 beispielsweise ist die längste, die im Rahmen aller Beispiele erhalten wurde.

In E14 (nicht erfindungsgemäß) enthält die Emissionsschicht neben der Mischung aus YD1 und H1 noch einen zusätzlichen roten Emitter RD1. In diesem Fall emittiert die OLED gelbes und rotes Licht simultan. Eine derartige Emissionsschicht kann beispielsweise, zusammen mit einer weiteren blauen Emissionsschicht, sehr attraktiv für den Bau einer weißen OLED sein. Auch in diesem Fall der Mischung einer Matrix mit zwei Emittern zeigen sich sehr gute Emissionsdaten.

Während in den bisherigen Beispielen E1 bis E14 stets der Emitter YD1 verwendet wurde, zeigen die Beispiele E15 bis E22 (E15-E18 nicht erfindungsgemäß) nun OLEDs unter Verwendung alternativer Emitter gemäß den oben beschriebenen Synthesebeispielen, gemischt mit H1 (nicht erfindungsgemäß) oder H3. Dabei entspricht YD2 dem Komplex aus Synthesebeispiel 2, YD3 dem Komplex aus Synthesebeispiel 3, etc..

Tabelle 1: Schichtaufbau der OLEDs

| Bsp | HIL Dicke | HTL Dicke | EBL Dicke | EML Dicke | ETL Dicke | EIL Dicke |
|---|---|---|---|---|---|---|
| E1* | HAT<br>5nm | SpMA1<br>70nm | SpMA2<br>20nm | H1:YD1 (90%:10%)<br>30nm | ST2:LiQ (50%:50%)<br>40nm | --- |
| E2* | HAT<br>5nm | SpMA1<br>70nm | SpMA2<br>20nm | H2:YD1 (90%:10%)<br>30nm | ST2:LiQ (50%:50%)<br>40nm | --- |
| E3 | HAT<br>5nm | SpMA1<br>70nm | SpMA2<br>20nm | H3:YD1 (90%:10%)<br>30nm | ST2:LiQ (50%:50%)<br>40nm | --- |
| E4* | HAT<br>5nm | SpMA1<br>70nm | SpMA2<br>20nm | H4:YD1 (90%:10%)<br>30nm | ST2:LiQ (50%:50%)<br>40nm | --- |
| E5* | HAT<br>5nm | SpMA1<br>70nm | SpMA2<br>20nm | H5:YD1 (90%:10%)<br>30nm | ST2:LiQ (50%:50%)<br>40nm | --- |
| E6* | HAT<br>5nm | SpMA1<br>70nm | SpMA2<br>20nm | H6:YD1 (90%:10%)<br>30nm | ST2:LiQ (50%:50%)<br>40nm | --- |
| E7* | HAT<br>5nm | SpMA1<br>70nm | SpMA2<br>20nm | H7:YD1 (90%:10%)<br>30nm | ST2:LiQ (50%:50%)<br>40nm | --- |
| E8* | HAT<br>5nm | SpMA1<br>70nm | SpMA2<br>20nm | H8:YD1 (90%:10%)<br>30nm | ST2:LiQ (50%:50%)<br>40nm | --- |

(fortgesetzt)

| Bsp | HIL Dicke | HTL Dicke | EBL Dicke | EML Dicke | ETL Dicke | EIL Dicke |
|---|---|---|---|---|---|---|
| E9* | HAT 5nm | SpMA1 70nm | SpMA2 20nm | H9:YD1 (90%:10%) 30nm | ST2:LiQ (50%:50%) 40nm | --- |
| E10* | HAT 5nm | SpMA1 70nm | SpMA2 20nm | ST2:YD1 (90%:10%) 30nm | ST2:LiQ (50%:50%) 40nm | --- |
| E11* | HAT 5nm | SpMA1 70nm | SpMA2 20nm | H1:YD1 (90%:10%) 30nm | ST2 40nm | LiQ 3nm |
| V1 | HAT 5nm | SpMA1 70nm | SpMA2 20nm | CH2:YD1 (90%:10%) 30nm | ST2:LiQ (50%:50%) 40nm | --- |
| V2 | HAT 5nm | SpMA1 70nm | SpMA2 20nm | SK:YD1 (90%:10%) 30nm | ST2:LiQ (50%:50%) 40nm | --- |
| V3 | HAT 5nm | SpMA1 70nm | SpMA2 20nm | CBP:YD1 (90%:10%) 30nm | ST2:LiQ (50%:50%) 40nm | --- |
| V4 | HAT 5nm | SpMA1 70nm | SpMA2 20nm | H1:Irppy (90%:10%) 30nm | ST2:LiQ (50%:50%) 40nm | --- |
| V5 | HAT 5nm | SpMA1 70nm | SpMA2 20nm | H2:Irppy (90%:10%) 30nm | ST2:LiQ (50%:50%) 40nm | --- |
| V6 | HAT 5nm | SpMA1 70nm | SpMA2 20nm | CH2:Irppy (90%:10%) 30nm | ST2:LiQ (50%:50%) 40nm | --- |
| V7 | HAT 5nm | SpMA1 70nm | SpMA2 20nm | SK:Irppy (90%:10%) 30nm | ST2:LiQ (50%:50%) 40nm | --- |
| V8 | HAT 5nm | SpMA1 70nm | SpMA2 20nm | CBP:Irppy (90%:10%) 30nm | ST2:LiQ (50%:50%) 40nm | --- |
| E12* | HAT 5nm | SpMA1 70nm | SpMA2 20nm | H1:CH1:YD1 (45%:45%:10%) 30nm | ST2:LiQ (50%:50%) 40nm | --- |
| E13* | HAT 5nm | SpMA1 70nm | SpMA2 20nm | H1:CH2:YD1 (45%:45%:10%) 30nm | ST2:LiQ (50%:50%) 40nm | --- |
| E14* | HAT 5nm | SpMA1 70nm | SpMA2 20nm | H1:YD1:RD1 (85%:14.8%:0.2%) 30nm | ST2:LiQ (50%:50%) 40nm | --- |
| E15* | HAT 5nm | SpMA1 70nm | SpMA2 20nm | H1:YD2 (90%:10%) 30nm | ST2:LiQ (50%:50%) 40nm | --- |
| E16* | HAT 5nm | SpMA1 70nm | SpMA2 20nm | H1:YD3 (90%:10%) 30nm | ST2:LiQ (50%:50%) 40nm | --- |
| E17* | HAT 5nm | SpMA1 70nm | SpMA2 20nm | H1:YD4 (90%:10%) 30nm | ST2:LiQ (50%:50%) 40nm | --- |
| E18* | HAT 5nm | SpMA1 70nm | SpMA2 20nm | H1:YD5 (90%:10%) 30nm | ST2:LiQ (50%:50%) 40nm | --- |
| E19 | HAT 5nm | SpMA1 70nm | SpMA2 20nm | H3:YD6 (90%:10%) 30nm | ST2:LiQ (50%:50%) 40nm | --- |
| E20 | HAT 5nm | SpMA1 70nm | SpMA2 20nm | H3:YD7 (90%:10%) 30nm | ST2:LiQ (50%:50%) 40nm | --- |
| E21 | HAT 5nm | SpMA1 70nm | SpMA2 20nm | H3:YD8 (90%:10%) 30nm | ST2:LiQ (50%:50%) 40nm | --- |

(fortgesetzt)

| Bsp | HIL Dicke | HTL Dicke | EBL Dicke | EML Dicke | ETL Dicke | EIL Dicke |
|---|---|---|---|---|---|---|
| E22 | HAT 5nm | SpMA1 70nm | SpMA2 20nm | H3:YD9 (90%:10%) 30nm | ST2:LiQ (50%:50%) 40nm | --- |
| * nicht erfindungsgemäß | | | | | | |

Tabelle 2: Emissionsdaten der OLEDs

| Bsp | U1000 (V) | SE1000 (cd/A) | LE1000 (lm/W) | EQE 1000 (%) | CIE x/y bei 1000 cd/$m^2$ | LD (h) |
|---|---|---|---|---|---|---|
| E1* | 2.87 | 79.2 | 86.7 | 22.7 | 0.44/0.55 | 340 000 |
| E2* | 3.41 | 76.7 | 70.5 | 21.9 | 0.44/0.55 | 320 000 |
| E3 | 2.91 | 80.0 | 86.7 | 23.0 | 0.44/0.55 | 300 000 |
| E4* | 3.90 | 69.4 | 56.0 | 19.5 | 0.43/0.56 | 240 000 |
| E5* | 3.05 | 75.5 | 77.7 | 21.7 | 0.44/0.55 | 270 000 |
| E6* | 3.17 | 80.7 | 80.2 | 23.2 | 0.44/0.55 | 320 000 |
| E7* | 3.02 | 78.8 | 78.1 | 22.5 | 0.44/0.55 | 280 000 |
| E8* | 2.88 | 75.6 | 82.4 | 21.7 | 0.43/0.56 | 210 000 |
| E9* | 3.02 | 77.6 | 80.7 | 22.2 | 0.44/0.55 | 280 000 |
| E10* | 2.85 | 78.1 | 86.0 | 22.3 | 0.43/0.55 | 230 000 |
| E11* | 2.56 | 79.6 | 97.7 | 23.1 | 0.45/0.55 | 270 000 |
| V1 | 2.91 | 56.3 | 60.8 | 16.1 | 0.44/0.55 | 150 000 |
| V2 | 3.14 | 55.4 | 55.4 | 16.0 | 0.44/0.55 | 45 000 |
| V3 | 5.55 | 20.7 | 11.7 | 6.0 | 0.42/0.55 | 5 300 |
| V4 | 3.32 | 47.3 | 44.9 | 13.3 | 0.35/0.61 | 42 000 |
| V5 | 3.99 | 51.7 | 41.1 | 14.7 | 0.38/0.58 | 66 000 |
| V6 | 2.97 | 43.3 | 45.9 | 12.0 | 0.34/0.62 | 26 000 |
| V7 | 3.74 | 48.2 | 40.5 | 14.2 | 0.38/0.58 | 31 000 |
| V8 | 5.92 | 24.7 | 12.2 | 7.1 | 0.30/0.61 | 5 600 |
| E12* | 2.95 | 75.1 | 80.1 | 21.5 | 0.44/0.56 | 250 000 |
| E13* | 2.81 | 69.6 | 78.0 | 20.0 | 0.44/0.55 | 400 000 |
| E14* | 3.23 | 58.3 | 56.7 | 20.7 | 0.51/0.55 | 310 000 |
| E15* | 2.92 | 80.4 | 86.5 | 22.9 | 0.45/0.54 | 280 000 |
| E16* | 2.83 | 81.1 | 90.0 | 23.1 | 0.44/0.55 | 260 000 |
| E17* | 3.14 | 38.9 | 89.0 | 20.8 | 0.58/0.42 | 220 000 |
| E18* | 2.95 | 79.4 | 84.5 | 22.6 | 0.46/0.54 | 320 000 |
| E19 | 2.96 | 77.3 | 82.0 | 21.9 | 0.44/0.55 | 190 000 |
| E20 | 2.88 | 80.8 | 87.2 | 23.1 | 0.46/0.54 | 300 000 |
| E21 | 3.09 | 43.0 | 43.7 | 22.5 | 0.56/0.43 | 340 000 |
| E22 | 3.26 | 28.6 | 27.5 | 19.7 | 0.64/0.36 | 150 000 |
| * nicht erfindungsgemäß | | | | | | |

Tabelle 3: Strukturformeln der Materialien für die OLEDs

| | |
|---|---|
| 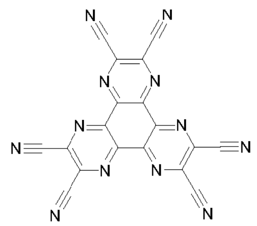 | 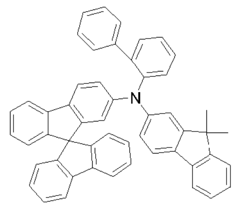 |
| HAT | SpMA1 |
| 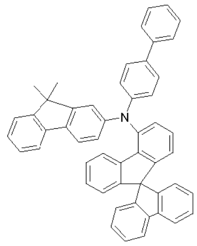 | |
| SpMA2 | |
| 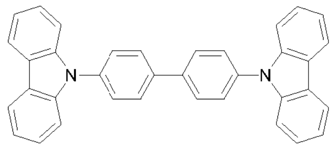 | 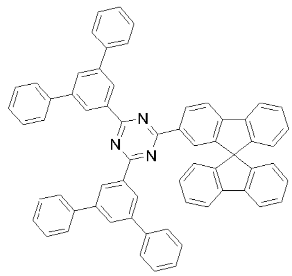 |
| CBP | ST2 |
| 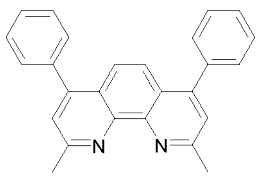 | 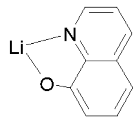 |
| BCP | LiQ |
| 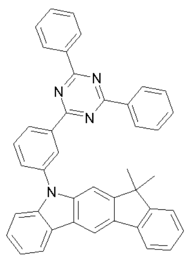 | 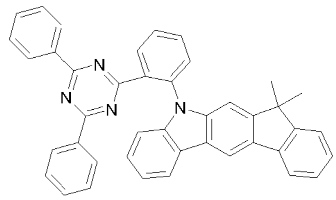 |
| H1 | H2 |

(fortgesetzt)

| | |
|---|---|
| 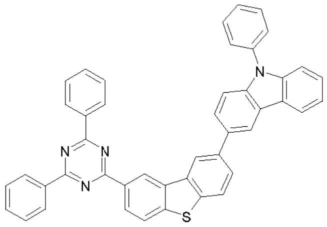 | 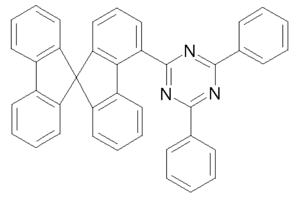 |
| H3 | H4 |
| 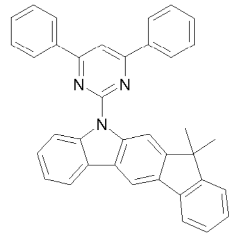 | 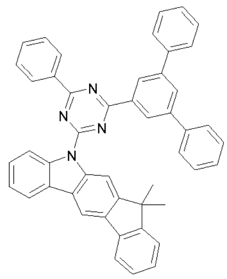 |
| H5 | H6 |
| 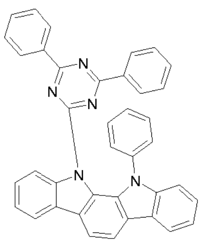 | 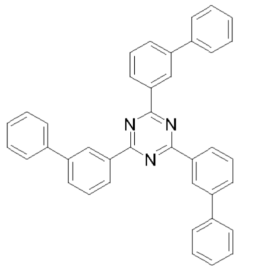 |
| H7 | H8 |
| 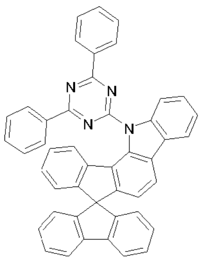 | |
| H9 | |
| 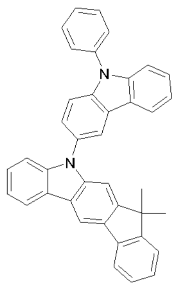 | 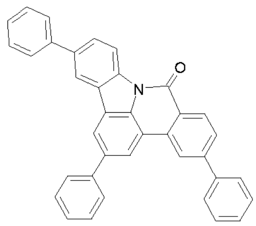 |
| CH1 | CH2 |

(fortgesetzt)

| | |
|---|---|
| 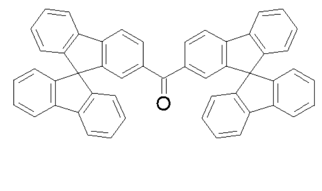 | 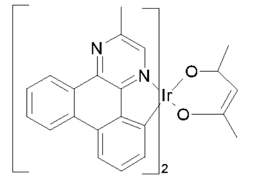 |
| SK | RD1 |
| 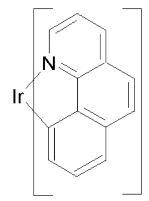 | 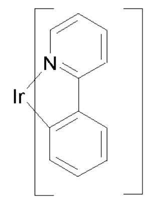 |
| YD1 | Irppy |

## Patentansprüche

**1.** Organische Elektrolumineszenzvorrichtung, enthaltend in der emittierenden Schicht eine Mischung aus einem Iridiumkomplex, welcher mindestens einen gegebenenfalls substituierten Benzochinolinliganden enthält, und einem Triazin- bzw. Pyrimidinderivat, welches ein Molekulargewicht von mindestens 350 g/mol aufweist, wobei das Triazinderivat eine Verbindung der Formel (1) und das Pyrimidinderivat eine Verbindung der Formel (2) ist,

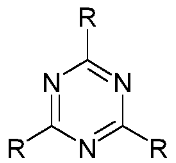

Formel (1)

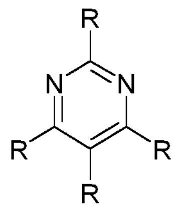

Formel (2)

wobei für die verwendeten Symbole gilt:

R ist bei jedem Auftreten gleich oder verschieden ausgewählt aus der Gruppe bestehend aus H, D, F, CN, $N(Ar)_2$, $N(R^1)_2$, C(=O)Ar, $C(=O)R^1$, $P(=O)(Ar)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^1$ substituiert sein kann, wobei eine oder mehrere nicht-benachbarte $CH_2$-Gruppen durch $R^1C=CR^1$, C≡C, $Si(R^1)_2$, C=O, C=S, $C=NR^1$, $P(=O)(R^1)$, SO, $SO_2$, $NR^1$, O, S oder $CONR^1$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 80, bevorzugt 5 bis 60, aromatischen Ringatomen, das jeweils mit einem oder mehreren Resten $R^1$ substituiert sein kann, einer Aryloxy- oder Heteroaryloxygruppe mit 5 bis 60 aromatischen Ringatomen, die mit einem oder mehreren Resten $R^1$ substituiert sein kann, oder einer Aralkyl- oder Heteroaralkylgruppe mit 5 bis 60 aromatischen Ringatomen, die mit einem oder mehreren Resten $R^1$ substituiert sein kann, wobei optional zwei oder mehr benachbarte Substituenten R ein monocyclisches oder polycyclisches, aliphatisches, aromatisches oder heteroaromatisches Ringsystem bilden können, das mit einem oder mehreren Resten $R^1$ substituiert sein kann;

$R^1$ ist bei jedem Auftreten gleich oder verschieden ausgewählt aus der Gruppe bestehend aus H, D, F, Cl, Br, I, CN, $NO_2$, $N(Ar)_2$, $N(R^2)_2$, C(=O)Ar, $C(=O)R^2$, $P(=O)(Ar)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^2$ substituiert sein kann, wobei eine oder mehrere nicht-benachbarte $CH_2$-Gruppen durch

$R^2C=CR^2$, C≡C, $Si(R^2)_2$, C=O, C=S, $C=NR^2$, $P(=O)(R^2)$, SO, $SO_2$, $NR^2$, O, S oder $CONR^2$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 60 aromatischen Ringatomen, das jeweils mit einem oder mehreren Resten $R^2$ substituiert sein kann, einer Aryloxy- oder Heteroaryloxygruppe mit 5 bis 60 aromatischen Ringatomen, die mit einem oder mehreren Resten $R^2$ substituiert sein kann, oder eine Aralkyl- oder Heteroaralkylgruppe mit 5 bis 60 aromatischen Ringatomen, wobei optional zwei oder mehr benachbarte Substituenten $R^1$ ein monocyclisches oder polycyclisches, aliphatisches, aromatisches oder heteroaromatisches Ringsystem bilden können, das mit einem oder mehreren Resten $R^2$ substituiert sein kann;
Ar ist bei jedem Auftreten gleich oder verschieden ein aromatisches oder heteroaromatisches Ringsystem mit 5-30 aromatischen Ringatomen, das mit einem oder mehreren nicht-aromatischen Resten $R^2$ substituiert sein kann; dabei können zwei Reste Ar, welche an dasselbe N-Atom oder P-Atom binden, auch durch eine Einfachbindung oder eine Brücke, ausgewählt aus $N(R^2)$, $C(R^2)_2$, O oder S, miteinander verbrückt sein;
$R^2$ ist ausgewählt aus der Gruppe bestehend aus H, D, F, CN, einem aliphatischem Kohlenwasserstoffrest mit 1 bis 20 C-Atomen, einem aromatischem oder heteroaromatischem Ringsystem mit 5 bis 30 aromatischen Ringatomen, in dem ein oder mehrere H-Atome durch D, F, Cl, Br, I oder CN ersetzt sein können, wobei zwei oder mehr benachbarte Substituenten $R^2$ miteinander ein mono- oder polycyclisches, aliphatisches, aromatisches oder heteroaromatisches Ringsystem bilden können;

**dadurch gekennzeichnet, dass** mindestens ein Rest R eine Gruppe der Formel (29) darstellt,

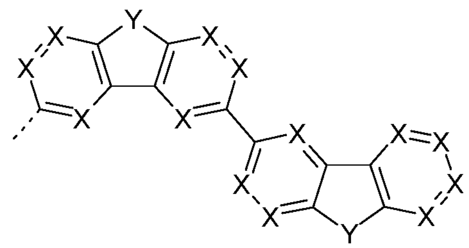

Formel (29)

wobei die gestrichelte Bindung die Bindung an die Triazineinheit in Formel (1) bzw. an die Pyrimidineinheit in Formel (2) darstellt und weiterhin gilt:

X ist bei jedem Auftreten gleich oder verschieden $CR^1$ oder N, wobei bevorzugt maximal 2 Symbole X pro Cyclus für N stehen;
Y ist bei jedem Auftreten gleich oder verschieden $C(R^1)_2$, $NR^1$, O, S oder $BR^1$, wobei $R^1$ die oben genannte Bedeutung aufweist.

**2.** Organische Elektrolumineszenzvorrichtung nach Anspruch 1, **dadurch gekennzeichnet, dass** das Triazinderivat ausgewählt ist aus den Verbindungen der Formel (1) und dass das Pyrimidinderivat ausgewählt ist aus den Verbindungen der Formeln (2a) bis (2d),

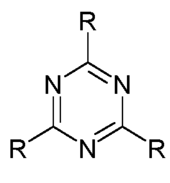 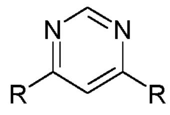 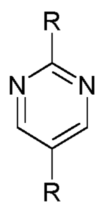 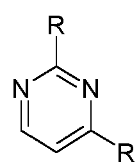 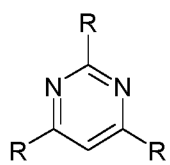

Formel (1) Formel (2a) Formel (2b) Formel (2c) Formel (2d)

wobei R gleich oder verschieden für ein aromatisches oder heteroaromatisches Ringsystem mit 5 bis 80 aromatischen Ringatomen steht, das jeweils mit einem oder mehreren Resten $R^1$ substituiert sein kann, und $R^1$ die in Anspruch 1 genannte Bedeutung aufweist.

**3.** Organische Elektrolumineszenzvorrichtung nach Anspruch 1 oder 2, **dadurch gekennzeichnet, dass** die aromatischen bzw. heteroaromatischen Ringsysteme 5 bis 30 aromatische Ringatome enthalten und durch einen oder mehrere Reste $R^1$ substituiert sein können, wobei sie bevorzugt keine kondensierten Aryl- bzw. Heteroarylgruppen enthalten, in denen mehr als zwei aromatische Sechsringe direkt aneinander ankondensiert sind.

**4.** Organische Elektrolumineszenzvorrichtung nach einem oder mehreren der Ansprüche 1 bis 3, **dadurch gekennzeichnet, dass** die Substituenten R ausgewählt sind aus der Gruppe bestehend aus Benzol, ortho-, meta- oder para-Biphenyl, ortho-, meta-, para- oder verzweigtem Terphenyl, ortho-, meta-, para- oder verzweigtem Quaterphenyl, 1-, 2-, 3- oder 4-Fluorenyl, 1-, 2-, 3- oder 4-Spirobifluorenyl, 1-oder 2-Naphthyl, Pyrrol, Furan, Thiophen, Indol, Benzofuran, Benzothiophen, 1-, 2- oder 3-Carbazol, 1-, 2-oder 3-Dibenzofuran, 1-, 2-oder 3-Dibenzothiophen, Indenocarbazol, Indolocarbazol, 2-, 3- oder 4-Pyridin, 2-, 4- oder 5-Pyrimidin, Pyrazin, Pyridazin, Triazin, Phenanthren, Triphenylen oder Kombinationen aus zwei oder drei dieser Gruppen, welche jeweils mit einem oder mehreren Resten $R^1$ substituiert sein können.

**5.** Organische Elektrolumineszenzvorrichtung nach einem oder mehreren der Ansprüche 1 bis 4, **dadurch gekennzeichnet, dass** mindestens eine Gruppe Y für $NR^1$ steht und der Substituent $R^1$, der an das Stickstoffatom gebunden ist, für ein aromatisches oder heteroaromatisches Ringsystem mit 5 bis 24 aromatischen Ringatomen steht, welches durch einen oder mehrere Reste $R^2$ substituiert sein kann, und/oder dass mindestens eine Gruppe Y für $C(R^1)_2$ steht und die Substituenten $R^1$, die an das Kohlenstoffatom gebunden sind, bei jedem Auftreten für eine lineare Alkylgruppe mit 1 bis 10 C-Atomen oder für eine verzweigte oder cyclische Alkylgruppe mit 3 bis 10 C-Atomen oder für ein aromatisches oder heteroaromatisches Ringsystem mit 5 bis 24 aromatischen Ringatomen, welches auch durch einen oder mehrere Reste $R^2$ substituiert sein kann, stehen, wobei die beiden Gruppen $R^1$, die an dasselbe Kohlenstoffatom binden, auch miteinander einen Ring bilden und so ein Spirosystem aufspannen können, welches durch einen oder mehrere Reste $R^2$ substituiert sein kann.

**6.** Organische Elektrolumineszenzvorrichtung nach einem oder mehreren der Ansprüche 1 bis 5, **dadurch gekennzeichnet, dass** der Iridiumkomplex, welcher mindestens einen gegebenenfalls substituierten Benzochinolinliganden enthält, eine Verbindung der Formel (30) ist,

$Ir(L)_m(L')_o$ Formel (30)

wobei $Ir(L)_m$ für eine Struktur der folgenden Formel (31) steht,

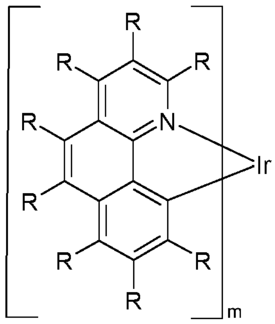

Formel (31)

wobei R die in Anspruch 1 genannten Bedeutungen aufweist, jedoch benachbarte Reste R kein aromatisches Ringsystem bilden können, und weiterhin gilt:

L' ist gleich oder verschieden bei jedem Auftreten ein bidentater monoanionischer Ligand;
m ist 1, 2 oder 3;
o ist 3 - m.

**7.** Organische Elektrolumineszenzvorrichtung nach Anspruch 6, **dadurch gekennzeichnet, dass** die Einheit der Formel $M(L)_m$ ausgewählt ist aus den Strukturen der Formel (31a),

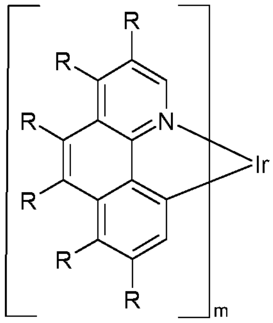

Formel (31a)

wobei die verwendeten Symbole und Indizes die in Anspruch 6 genannten Bedeutungen aufweisen.

8. Organische Elektrolumineszenzvorrichtung nach Anspruch 6 oder 7, **dadurch gekennzeichnet, dass** R gleich oder verschieden bei jedem Auftreten ausgewählt ist aus der Gruppe bestehend aus H, F, CN, einer geradkettigen Alkylgruppe mit 1 bis 6 C-Atomen oder einer verzweigten oder cyclischen Alkylgruppe mit 3 bis 6 C-Atomen, die jeweils mit einem oder mehreren Resten $R^1$ substituiert sein kann, oder einem aromatischen oder heteroaromatischen Ringsystem mit 5 bis 14 aromatischen Ringatomen, das jeweils mit einem oder mehreren Resten $R^1$ substituiert sein kann, wobei optional zwei oder mehr benachbarte Substituenten R ein monocyclisches oder polycyclisches, aliphatisches Ringsystem bilden können, das mit einem oder mehreren Resten $R^1$ substituiert sein kann, wobei im Liganden L maximal drei Substituenten R ungleich Wasserstoff sind.

9. Organische Elektrolumineszenzvorrichtung nach einem oder mehreren der Ansprüche 6 bis 8, **dadurch gekennzeichnet, dass** L' ausgewählt ist aus 1,3-Diketonaten abgeleitet von 1,3-Diketonen, 3-Ketonaten abgeleitet von 3-Ketoestern, Carboxylaten abgeleitet von Aminocarbonsäuren, Salicyliminaten abgeleitet von Salicyliminen, oder bidentaten monoanionischen Liganden, welche mit dem Metall einen cyclometallierten Fünfring oder Sechsring mit mindestens einer Metall-Kohlenstoff-Bindung bilden.

10. Organische Elektrolumineszenzvorrichtung nach einem oder mehreren der Ansprüche 1 bis 9, **dadurch gekennzeichnet, dass** sie mehrere emittierende Schichten enthält, so dass insgesamt weiße Emission resultiert.

11. Verfahren zur Herstellung einer organischen Elektrolumineszenzvorrichtung nach einem oder mehreren der Ansprüche 1 bis 10, **dadurch gekennzeichnet, dass** mindestens eine Schicht mit einem Sublimationsverfahren aufgebracht wird und/oder dass mindestens eine Schicht mit einem Organic Vapour Phase Deposition Verfahren oder mit Hilfe einer Trägergassublimation aufgebracht wird und/oder dass mindestens eine Schicht aus Lösung, durch Spincoating oder mit einem Druckverfahren aufgebracht wird.

12. Mischung, enthaltend mindestens einen Iridiumkomplex, welcher mindestens einen gegebenenfalls substituierten Benzochinolinliganden enthält, und mindestens ein Triazin- bzw. Pyrimidinderivat, welches ein Molekulargewicht von mindestens 350 g/mol aufweist, wobei das Triazinderivat eine Verbindung der Formel (1) und das Pyrimidinderivat eine Verbindung der Formel (2) ist,

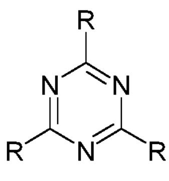

Formel (1)

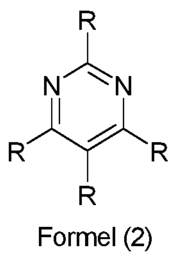

Formel (2)

wobei für die verwendeten Symbole gilt:

R ist bei jedem Auftreten gleich oder verschieden ausgewählt aus der Gruppe bestehend aus H, D, F, CN, $N(Ar)_2$, $N(R^1)_2$, C(=O)Ar, C(=O)$R^1$, P(=O)$(Ar)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^1$ substituiert sein kann, wobei eine oder mehrere nicht-benachbarte $CH_2$-Gruppen durch $R^1C=CR^1$, $C\equiv C$, $Si(R^1)_2$, C=O, C=S, $C=NR^1$, $P(=O)(R^1)$, SO, $SO_2$, $NR^1$, O, S oder $CONR^1$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 80, bevorzugt 5 bis 60, aromatischen Ringatomen, das jeweils mit einem oder mehreren Resten $R^1$ substituiert sein kann, einer Aryloxy- oder Heteroaryloxygruppe mit 5 bis 60 aromatischen Ringatomen, die mit einem oder mehreren Resten $R^1$ substituiert sein kann, oder einer Aralkyl- oder Heteroaralkylgruppe mit 5 bis 60 aromatischen Ringatomen, die mit einem oder mehreren Resten $R^1$ substituiert sein kann, wobei optional zwei oder mehr benachbarte Substituenten R ein monocyclisches oder polycyclisches, aliphatisches, aromatisches oder heteroaromatisches Ringsystem bilden können, das mit einem oder mehreren Resten $R^1$ substituiert sein kann;

$R^1$ ist bei jedem Auftreten gleich oder verschieden ausgewählt aus der Gruppe bestehend aus H, D, F, Cl, Br, I, CN, $NO_2$, $N(Ar)_2$, $N(R^2)_2$, C(=O)Ar, $C(=O)R^2$, $P(=O)(Ar)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^2$ substituiert sein kann, wobei eine oder mehrere nicht-benachbarte $CH_2$-Gruppen durch $R^2C=CR^2$, $C\equiv C$, $Si(R^2)_2$, C=O, C=S, $C=NR^2$, $P(=O)(R^2)$, SO, $SO_2$, $NR^2$, O, S oder $CONR^2$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 60 aromatischen Ringatomen, das jeweils mit einem oder mehreren Resten $R^2$ substituiert sein kann, einer Aryloxy- oder Heteroaryloxygruppe mit 5 bis 60 aromatischen Ringatomen, die mit einem oder mehreren Resten $R^2$ substituiert sein kann, oder eine Aralkyl- oder Heteroaralkylgruppe mit 5 bis 60 aromatischen Ringatomen, wobei optional zwei oder mehr benachbarte Substituenten $R^1$ ein monocyclisches oder polycyclisches, aliphatisches, aromatisches oder heteroaromatisches Ringsystem bilden können, das mit einem oder mehreren Resten $R^2$ substituiert sein kann;

Ar ist bei jedem Auftreten gleich oder verschieden ein aromatisches oder heteroaromatisches Ringsystem mit 5-30 aromatischen Ringatomen, das mit einem oder mehreren nicht-aromatischen Resten $R^2$ substituiert sein kann; dabei können zwei Reste Ar, welche an dasselbe N-Atom oder P-Atom binden, auch durch eine Einfachbindung oder eine Brücke, ausgewählt aus $N(R^2)$, $C(R^2)_2$, O oder S, miteinander verbrückt sein;

$R^2$ ist ausgewählt aus der Gruppe bestehend aus H, D, F, CN, einem aliphatischem Kohlenwasserstoffrest mit 1 bis 20 C-Atomen, einem aromatischem oder heteroaromatischem Ringsystem mit 5 bis 30 aromatischen Ringatomen, in dem ein oder mehrere H-Atome durch D, F, Cl, Br, I oder CN ersetzt sein können, wobei zwei oder mehr benachbarte Substituenten $R^2$ miteinander ein mono- oder polycyclisches, aliphatisches, aromatisches oder heteroaromatisches Ringsystem bilden können;

**dadurch gekennzeichnet, dass** mindestens ein Rest R eine Gruppe der Formel (29) darstellt,

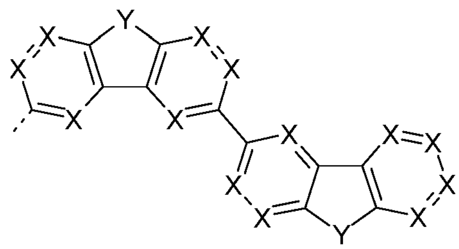

Formel (29)

wobei die gestrichelte Bindung die Bindung an die Triazineinheit in Formel (1) bzw. an die Pyrimidineinheit in Formel (2) darstellt und weiterhin gilt:

X ist bei jedem Auftreten gleich oder verschieden $CR^1$ oder N, wobei bevorzugt maximal 2 Symbole X pro Cyclus für N stehen;

Y ist bei jedem Auftreten gleich oder verschieden $C(R^1)_2$, $NR^1$, O, S oder $BR^1$, wobei $R^1$ die oben genannte Bedeutung aufweist.

**13.** Formulierung, enthaltend mindestens eine Mischung nach Anspruch 12 und mindestens ein organisches Lösemittel.

## Claims

1. Organic electroluminescent device containing in the emitting layer a mixture of an iridium complex which contains at least one optionally substituted benzoquinoline ligand, and a triazine or pyrimidine derivative which has a molecular weight of at least 350 g/mol , where the triazine derivative is a compound of the formula (1) and the pyrimidine derivative is a compound of the formula (2),

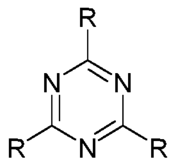

formula (1)

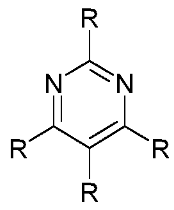

formula (2)

where the following applies to the symbols used:

R is selected on each occurrence, identically or differently, from the group consisting of H, D, F, CN, $N(Ar)_2$, $N(R^1)_2$, C(=O)Ar, $C(=O)R^1$, $P(=O)(Ar)_2$, a straight-chain alkyl, alkoxy or thioalkyl group having 1 to 40 C atoms or a branched or cyclic alkyl, alkoxy or thioalkyl group having 3 to 40 C atoms or an alkenyl or alkynyl group having 2 to 40 C atoms, which may in each case be substituted by one or more radicals $R^1$, where one or more non-adjacent $CH_2$ groups may be replaced by $R^1C=CR^1$, C=C, $Si(R^1)_2$, C=O, C=S, $C=NR^1$, $P(=O)(R^1)$, SO, $SO_2$, $NR^1$, O, S or $CONR^1$ and where one or more H atoms may be replaced by D, F, Cl, Br, I, CN or $NO_2$, an aromatic or heteroaromatic ring system having 5 to 80, preferably 5 to 60, aromatic ring atoms, which may in each case be substituted by one or more radicals $R^1$, an aryloxy or heteroaryloxy group having 5 to 60 aromatic ring atoms, which may be substituted by one or more radicals $R^1$, or an aralkyl or heteroaralkyl group having 5 to 60 aromatic ring atoms, which may be substituted by one or more radicals $R^1$, where two or more adjacent substituents R may optionally form a monocyclic or polycyclic, aliphatic, aromatic or heteroaromatic ring system, which may be substituted by one or more radicals $R^1$;

$R^1$ is selected on each occurrence, identically or differently, from the group consisting of H, D, F, Cl, Br, I, CN, $NO_2$, $N(Ar)_2$, $N(R^2)_2$, C(=O)Ar, $C(=O)R^2$, $P(=O)(Ar)_2$, a straight-chain alkyl, alkoxy or thioalkyl group having 1 to 40 C atoms or a branched or cyclic alkyl, alkoxy or thioalkyl group having 3 to 40 C atoms or an alkenyl or alkynyl group having 2 to 40 C atoms, which may in each case be substituted by one or more radicals $R^2$, where one or more non-adjacent $CH_2$ groups may be replaced by $R^2C=CR^2$, $C\equiv C$, $Si(R^2)_2$, C=O, C=S, $C=NR^2$, $P(=O)(R^2)$, SO, $SO_2$, $NR^2$, O, S or $CONR^2$ and where one or more H atoms may be replaced by D, F, Cl, Br, I, CN or $NO_2$, an aromatic or heteroaromatic ring system having 5 to 60 aromatic ring atoms, which may in each case be substituted by one or more radicals $R^2$, an aryloxy or heteroaryloxy group having 5 to 60 aromatic ring atoms, which may be substituted by one or more radicals $R^2$, or an aralkyl or heteroaralkyl group having 5 to 60 aromatic ring atoms, where two or more adjacent substituents $R^1$ may optionally form a monocyclic or polycyclic, aliphatic, aromatic or heteroaromatic ring system, which may be substituted by one or more radicals $R^2$;

Ar is on each occurrence, identically or differently, an aromatic or heteroaromatic ring system having 5-30 aromatic ring atoms, which may be substituted by one or more non-aromatic radicals $R^2$; two radicals Ar which are bonded to the same N atom or P atom may also be bridged to one another by a single bond or a bridge selected from $N(R^2)$, $C(R^2)_2$, O or S;

$R^2$ is selected from the group consisting of H, D, F, CN, an aliphatic hydrocarbon radical having 1 to 20 C atoms, an aromatic or heteroaromatic ring system having 5 to 30 aromatic ring atoms, in which one or more H atoms may be replaced by D, F, Cl, Br, I or CN, where two or more adjacent substituents $R^2$ may form a mono- or polycyclic, aliphatic, aromatic or heteroaromatic ring system with one another;

**characterised in that** at least one radical R represents a group of the formula (29),

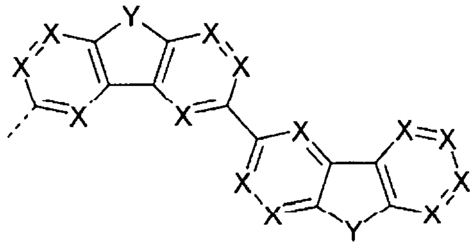

formula (29)

where the dashed bond represents the bond to the triazine unit in formula (1) or to the pyrimidine unit in formula (2) and furthermore:

X is on each occurrence, identically or differently, $CR^1$ or N, where preferably a maximum of 2 symbols X per ring stand for N;
Y is on each occurrence, identically or differently, $C(R^1)_2$, $NR^1$, O, S or $BR^1$, where $R^1$ has the above-mentioned meaning.

2. Organic electroluminescent device according to Claim 1, **characterised in that** the triazine derivative is selected from the compounds of the formula (1) and **in that** the pyrimidine derivative is selected from the compounds of the formulae (2a) to (2d),

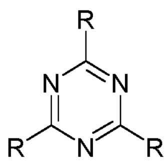

formula (1)

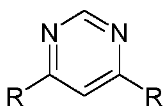

formula (2a)

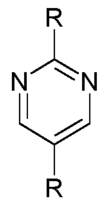

formula (2b)

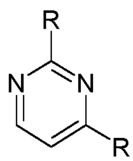

formula (2c)

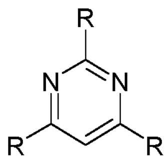

formula (2d)

where R stands, identically or differently, for an aromatic or heteroaromatic ring system having 5 to 80 aromatic ring atoms, which may in each case be substituted by one or more radicals $R^1$, and $R^1$ has the meaning given in Claim 1.

3. Organic electroluminescent device according to Claim 1 or 2, **characterised in that** the aromatic or heteroaromatic ring systems contain 5 to 30 aromatic ring atoms and may be substituted by one or more radicals $R^1$, where they preferably contain no condensed aryl or heteroaryl groups in which more than two aromatic six-membered rings are condensed directly onto one another.

4. Organic electroluminescent device according to one or more of Claims 2 to 4, **characterised in that** the substituents R are selected from the group consisting of benzene, ortho-, meta- or para-biphenyl, ortho-, meta-, para- or branched terphenyl, ortho-, meta-, para- or branched quaterphenyl, 1-, 2-, 3- or 4-fluorenyl, 1-, 2-, 3- or 4-spirobifluorenyl, 1- or 2-naphthyl, pyrrole, furan, thiophene, indole, benzofuran, benzothiophene, 1-, 2- or 3-carbazole, 1-, 2- or 3-dibenzofuran, 1-, 2- or 3-dibenzothiophene, indenocarbazole, indolocarbazole, 2-, 3- or 4-pyridine, 2-, 4- or 5-pyrimidine, pyrazine, pyridazine, triazine, phen-anthrene, triphenylene or combinations of two or three of these groups, which may in each case be substituted by one or more radicals $R^1$.

5. Organic electroluminescent device according to one or more of Claims 1 to 4, **characterised in that** at least one group Y stands for $NR^1$ and the substituent $R^1$ that is bonded to the nitrogen atom stands for an aromatic or heteroaromatic ring system having 5 to 24 aromatic ring atoms, which may be substituted by one or more radicals $R^2$, and/or **in that** at least one group Y stands for $C(R^1)_2$ and the substituents $R^1$ thatr are bonded to the carbon atom stand on each occurrence for a linear alkyl group having 1 to 10 C atoms or for a branched or cyclic alkyl group having 3 to 10 C atoms or for an aromatic or heteroaromatic ring system having 5 to 24 aromatic ring atoms, which may also be substituted by one or more radicals $R^2$, where the two groups $R^1$ that are bonded to the same carbon atom may also form a ring with one another and thus form a spiro system, which may be substituted by one or more radicals $R^2$.

6. Organic electroluminescent device according to one or more of Claims 1 to 5, **characterised in that** the iridium complex which contains at least one optionally substituted benzoquinoline ligand is a compound of the formula (30),

$Ir(L)_m(L')_o$ formula (30)

where $Ir(L)_m$ stands for a structure of the following formula (31),

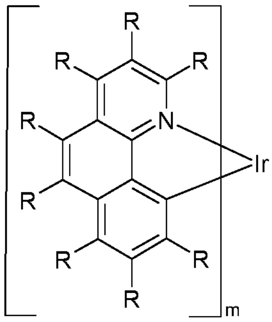

formula (31)

where R has the meanings given in Claim 1, but adjacent radicals R cannot form an aromatic ring system, and furthermore:

L' is, identically or differently on each occurrence, a bidentate mono-anionic ligand;
m is 1, 2 or 3;
o is3-m.

7. Organic electroluminescent device according to Claim 6, **characterised in that** the unit of the formula $M(L)_m$ is selected from the structures of the formula (31a),

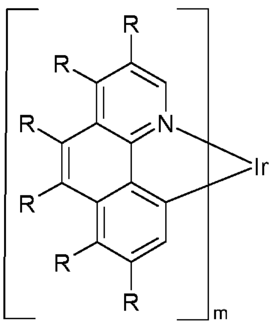

formula (31a)

where the symbols and indices used have the meanings given in Claim 6.

8. Organic electroluminescent device according to Claim 6 or 7, **characterised in that** R is selected, identically or differently on each occurrence, from the group consisting of H, F, CN, a straight-chain alkyl group having 1 to 6 C atoms or a branched or cyclic alkyl group having 3 to 6 C atoms, which may in each case be substituted by one or more radicals $R^1$, or an aromatic or heteroaromatic ring system having 5 to 14 aromatic ring atoms, which may in each case be substituted by one or more radicals $R^1$, where two or more adjacent substituents R may optionally form a monocyclic or polycyclic, aliphatic ring system, which may be substituted by one or more radicals $R^1$, where a maximum of three substituents R in the ligand L are not equal to hydrogen.

9. Organic electroluminescent device according to one or more of Claims 6 to 8, **characterised in that** L' is selected from 1,3-diketonates derived from 1,3-diketones, 3-ketonates derived from 3-ketoesters, carboxylates derived from aminocarboxylic acids, salicyliminates derived from salicylimines, or bidentate monoanionic ligands which, with the metal, form a cyclometallated five-membered ring or six-membered ring having at least one metal-carbon bond.

10. Organic electroluminescent device according to one or more of Claims 1 to 9, **characterised in that** it comprises a plurality of emitting layers, resulting overall in white emission.

**11.** Process for the production of an organic electroluminescent device according to one or more of Claims 1 to 10, **characterised in that** at least one layer is applied by means of a sublimation method and/or **in that** at least one layer is applied by means of an organic vapour-phase deposition method or with the aid of carrier-gas sublimation and/or **in that** at least one layer is applied from solution, by spin coating or by means of a printing process.

**12.** Mixture comprising at least one iridium complex which contains at least one optionally substituted benzoquinoline ligand, and at least one triazine or pyrimidine derivative which has a molecular weight of at least 350 g/mol, where the triazine derivative is a compound of the formula (1) and the pyrimidine derivative is a compound of the formula (2),

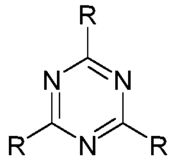
formula (1)

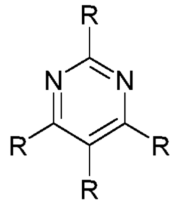
formula (2)

where the following applies to the symbols used:

R is selected on each occurrence, identically or differently, from the group consisting of H, D, F, CN, $N(Ar)_2$, $N(R^1)_2$, C(=O)Ar, $C(=O)R^1$, $P(=O)(Ar)_2$, a straight-chain alkyl, alkoxy or thioalkyl group having 1 to 40 C atoms or a branched or cyclic alkyl, alkoxy or thioalkyl group having 3 to 40 C atoms or an alkenyl or alkynyl group having 2 to 40 C atoms, which may in each case be substituted by one or more radicals $R^1$, where one or more non-adjacent $CH_2$ groups may be replaced by $R^1C=CR^1$, C≡C, $Si(R^1)_2$, C=O, C=S, $C=NR^1$, $P(=O)(R^1)$, SO, $SO_2$, $NR^1$, O, S or $CONR^1$ and where one or more H atoms may be replaced by D, F, Cl, Br, I, CN or $NO_2$, an aromatic or heteroaromatic ring system having 5 to 80, preferably 5 to 60, aromatic ring atoms, which may in each case be substituted by one or more radicals $R^1$, an aryloxy or heteroaryloxy group having 5 to 60 aromatic ring atoms, which may be substituted by one or more radicals $R^1$, or an aralkyl or heteroaralkyl group having 5 to 60 aromatic ring atoms, which may be substituted by one or more radicals $R^1$, where two or more adjacent substituents R may optionally form a monocyclic or polycyclic, aliphatic, aromatic or heteroaromatic ring system, which may be substituted by one or more radicals $R^1$;

$R^1$ is selected on each occurrence, identically or differently, from the group consisting of H, D, F, Cl, Br, I, CN, $NO_2$, $N(Ar)_2$, $N(R^2)_2$, C(=O)Ar, $C(=O)R^2$, $P(=O)(Ar)_2$, a straight-chain alkyl, alkoxy or thioalkyl group having 1 to 40 C atoms or a branched or cyclic alkyl, alkoxy or thioalkyl group having 3 to 40 C atoms or an alkenyl or alkynyl group having 2 to 40 C atoms, which may in each case be substituted by one or more radicals $R^2$, where one or more non-adjacent $CH_2$ groups may be replaced by $R^2C=CR^2$, C≡C, $Si(R^2)_2$, C=O, C=S, $C=NR^2$, $P(=O)(R^2)$, SO, $SO_2$, $NR^2$, O, S or $CONR^2$ and where one or more H atoms may be replaced by D, F, Cl, Br, I, CN or $NO_2$, an aromatic or heteroaromatic ring system having 5 to 60 aromatic ring atoms, which may in each case be substituted by one or more radicals $R^2$, an aryloxy or heteroaryloxy group having 5 to 60 aromatic ring atoms, which may be substituted by one or more radicals $R^2$, or an aralkyl or heteroaralkyl group having 5 to 60 aromatic ring atoms, where two or more adjacent substituents $R^1$ may optionally form a monocyclic or polycyclic, aliphatic, aromatic or heteroaromatic ring system, which may be substituted by one or more radicals $R^2$;

Ar is on each occurrence, identically or differently, an aromatic or heteroaromatic ring system having 5-30 aromatic ring atoms, which may be substituted by one or more non-aromatic radicals $R^2$; two radicals Ar which are bonded to the same N atom or P atom may also be bridged to one another by a single bond or a bridge selected from $N(R^2)$, $C(R^2)_2$, O or S;

$R^2$ is selected from the group consisting of H, D, F, CN, an aliphatic hydrocarbon radical having 1 to 20 C atoms, an aromatic or heteroaromatic ring system having 5 to 30 aromatic ring atoms, in which one or more H atoms may be replaced by D, F, Cl, Br, I or CN, where two or more adjacent substituents $R^2$ may form a mono- or polycyclic, aliphatic, aromatic or heteroaromatic ring system with one another;

**characterised in that** at least one radical R represents a group of the formula (29),

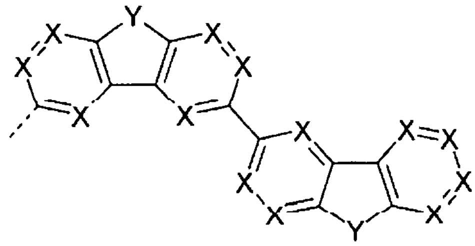

formula (29)

represents the bond to the triazine unit in formula (1) or to the pyrimidine unit in formula (2) and furthermore:

X is on each occurrence, identically or differently, $CR^1$ or N, where preferably a maximum of 2 symbols X per ring stand for N;
Y is on each occurrence, identically or differently, $C(R^1)_2$, $NR^1$, O, S or $BR^1$, where $R^1$ has the above-mentioned meaning.

**13.** Formulation comprising at least one mixture according to Claim 12 and at least one organic solvent.

**Revendications**

**1.** Dispositif électroluminescent organique contenant dans la couche d'émission un mélange constitué par un complexe d'iridium qui contient au moins un ligand benzoquinoline en option substitué, et un dérivé de triazine ou de pyrimidine qui présente un poids moléculaire d'au moins 350 g/mol, où le dérivé de triazine est un composé de la formule (1) et le dérivé de pyrimidine est un composé de la formule (2),

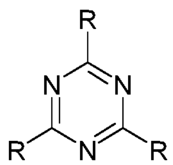

formule (1)

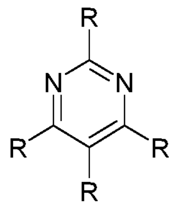

formule (2)

dans lesquelles ce qui suit s'applique aux symboles qui sont utilisés :

R est sélectionné pour chaque occurrence, de manière identique ou différente, parmi le groupe qui est constitué par H, D, F, CN, $N(Ar)_2$, $N(R^1)_2$, C(=O)Ar, $C(=O)R^1$, $P(=O)(Ar)_2$, un groupe alkyle, alcoxy ou thioalkyle en chaîne droite qui comporte de 1 à 40 atome(s) de C ou un groupe alkyle, alcoxy ou thioalkyle ramifié ou cyclique qui comporte de 3 à 40 atomes de C ou un groupe alkényle ou alkynyle qui comporte de 2 à 40 atomes de C, lequel peut dans chaque cas être substitué par un radical ou par plusieurs radicaux $R^1$, où un ou plusieurs groupe(s) $CH_2$ non adjacents peut/peuvent être remplacé(s) par $R^1C=CR^1$, C=C, $Si(R^1)_2$, C=O, C=S, $C=NR^1$, $P(=O)(R^1)$, SO, $SO_2$, $NR^1$, O, S ou $CONR^1$ et où un ou plusieurs atome(s) de H peut/peuvent être remplacé(s) par D, F, Cl, Br, I, CN ou $NO_2$, un système de cycle aromatique ou hétéroaromatique qui comporte de 5 à 80, de préférence de 5 à 60, atomes de cycle aromatique, lequel peut dans chaque cas être substitué par un radical ou par plusieurs radicaux $R^1$, un groupe aryloxy ou hétéroaryloxy qui comporte de 5 à 60 atomes de cycle aromatique, lequel peut être substitué par un radical ou par plusieurs radicaux $R^1$, ou un groupe aralkyle ou hétéroaralkyle qui comporte de 5 à 60 atomes de cycle aromatique, lequel peut être substitué par un radical ou par plusieurs radicaux $R^1$, où deux substituants R adjacents ou plus peuvent en option former un système de cycle aliphatique, aromatique ou hétéroaromatique monocyclique ou polycyclique, lequel peut être substitué par un radical ou par plusieurs radicaux $R^1$ ;
$R^1$ est sélectionné pour chaque occurrence, de manière identique ou différente, parmi le groupe qui est constitué par H, D, F, Cl, Br, I, CN, $NO_2$, $N(Ar)_2$, $N(R^2)_2$, C(=O)Ar, $C(=O)R^2$, $P(=O)(Ar)_2$, un groupe alkyle, alcoxy ou thioalkyle en chaîne droite qui comporte de 1 à 40 atome(s) de C ou un groupe alkyle, alcoxy ou thioalkyle

ramifié ou cyclique qui comporte de 3 à 40 atomes de C ou un groupe alkényle ou alkynyle qui comporte de 2 à 40 atomes de C, lequel peut dans chaque cas être substitué par un radical ou par plusieurs radicaux $R^2$, où un ou plusieurs groupe(s) $CH_2$ non adjacents peut/peuvent être remplacé(s) par $R^2C=CR^2$, C≡C, $Si(R^2)_2$, C=O, C=S, $C=NR^2$, $P(=O)(R^2)$, SO, $SO_2$, $NR^2$, O, S ou $CONR^2$ et où un ou plusieurs atome(s) de H peut/peuvent être remplacé(s) par D, F, Cl, Br, I, CN ou $NO_2$, un système de cycle aromatique ou hétéroaromatique qui comporte de 5 à 60 atomes de cycle aromatique, lequel peut dans chaque cas être substitué par un radical ou par plusieurs radicaux $R^2$, un groupe aryloxy ou hétéroaryloxy qui comporte de 5 à 60 atomes de cycle aromatique, lequel peut être substitué par un radical ou par plusieurs radicaux $R^2$, ou un groupe aralkyle ou hétéroaralkyle qui comporte de 5 à 60 atomes de cycle aromatique, où deux substituants $R^1$ adjacents ou plus peuvent en option former un système de cycle aliphatique, aromatique ou hétéroaromatique monocyclique ou polycyclique, lequel peut être substitué par un radical ou par plusieurs radicaux $R^2$ ;

Ar est pour chaque occurrence, de manière identique ou différente, un système de cycle aromatique ou hétéroaromatique qui comporte de 5 à 30 atomes de cycle aromatique, lequel peut être substitué par un radical ou par plusieurs radicaux $R^2$ non aromatique(s) ; deux radicaux Ar qui sont liés au même atome de N ou au même atome de P peuvent également être pontés l'un à l'autre par une liaison simple ou un pont qui est sélectionné parmi $N(R^2)$, $C(R^2)_2$, O ou S;

$R^2$ est sélectionné parmi le groupe qui est constitué par H, D, F, CN, un radical hydrocarbone aliphatique qui comporte de 1 à 20 atome(s) de C, un système de cycle aromatique ou hétéroaromatique qui comporte de 5 à 30 atomes de cycle aromatique, où un ou plusieurs atome(s) de H peut/peuvent être remplacé(s) par D, F, Cl, Br, I ou par CN, où deux substituants $R^2$ adjacents ou plus peuvent former un système de cycle aliphatique, aromatique ou hétéroaromatique monocyclique ou polycyclique l'un avec l'autre ou les uns avec les autres ;

**caractérisé en ce qu'**au moins un radical R représente un groupe de la formule (29),

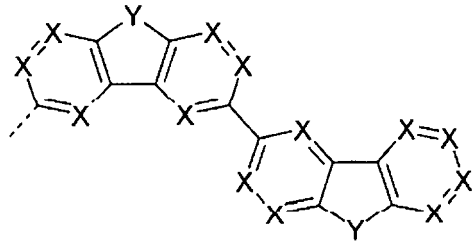

formule (29)

dans laquelle la liaison en pointillés représente la liaison sur l'unité de triazine dans la formule (1) ou sur l'unité de pyrimidine dans la formule (2) et en outre :

X est pour chaque occurrence, de manière identique ou différente, $CR^1$ ou N, où, de préférence, un maximum de 2 symboles X par cycle représentent N ;

Y est pour chaque occurrence, de manière identique ou différente, $C(R^1)_2$, $NR^1$, O, S ou $BR^1$, où $R^1$ présente la signification qui a été mentionnée ci-avant.

2. Dispositif électroluminescent organique selon la revendication 1, **caractérisé en ce que** le dérivé de triazine est sélectionné parmi les composés de la formule (1) et **en ce que** le dérivé de pyrimidine est sélectionné parmi les composés des formules (2a) à (2d),

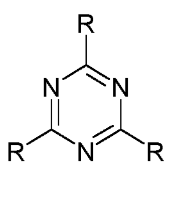
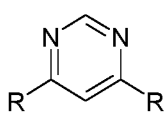
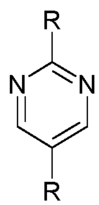
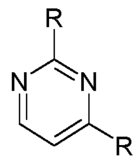
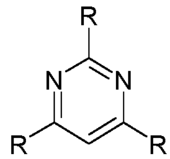

formule (1) formule (2a) formule (2b) formule (2c) formule (2d)

dans lesquelles R représente, de manière identique ou différente, un système de cycle aromatique ou hétéroaromatique qui comporte de 5 à 80 atomes de cycle aromatique, lequel peut dans chaque cas être substitué par un radical ou par plusieurs radicaux $R^1$, et $R^1$ présente la signification qui a été donnée selon la revendication 1.

**3.** Dispositif électroluminescent organique selon la revendication 1 ou 2, **caractérisé en ce que** les systèmes de cycle aromatique ou hétéroaromatique contiennent de 5 à 30 atomes de cycle aromatique et peuvent être substitués par un radical ou par plusieurs radicaux $R^1$, où, de préférence, ils ne contiennent pas de groupes aryle ou hétéroaryle condensés dans lesquels plus de deux cycles à six éléments aromatiques sont condensés directement les uns sur les autres.

**4.** Dispositif électroluminescent organique selon une ou plusieurs des revendications 2 à 4, **caractérisé en ce que** les substituants R sont sélectionnés parmi le groupe qui est constitué par benzène, ortho-, méta- ou para-biphényle, ortho-, méta-, para- ou terphényle ramifié, ortho-, méta-, para- ou quaterphényle ramifié, 1-, 2-, 3- ou 4-fluorényle, 1-, 2-, 3- ou 4-spirobifluorényle, 1- ou 2-naphtyle, pyrrole, furane, thiophène, indole, benzofurane, benzothiophène, 1-, 2- ou 3-carbazole, 1-, 2- ou 3-dibenzofurane, 1-, 2- ou 3-dibenzothiophène, indénocarbazole, indolocarbazole, 2-, 3- ou 4-pyridine, 2-, 4- ou 5-pyrimidine, pyrazine, pyridazine, triazine, phénanthrène, triphénylène ou des combinaisons de deux ou trois de ces groupes, lesquels peuvent dans chaque cas être substitués par un radical ou par plusieurs radicaux $R^1$.

**5.** Dispositif électroluminescent organique selon une ou plusieurs des revendications 1 à 4, **caractérisé en ce qu'**au moins un groupe Y représente $NR^1$ et le substituant $R^1$ qui est lié à l'atome d'azote représente un système de cycle aromatique ou hétéroaromatique qui comporte de 5 à 24 atomes de cycle aromatique, lequel peut être substitué par un radical ou par plusieurs radicaux $R^2$, et/ou **en ce qu'**au moins un groupe Y représente $C(R^1)_2$ et les substituants $R^1$ qui sont liés à l'atome de carbone représentent pour chaque occurrence un groupe alkyle linéaire qui comporte de 1 à 10 atome(s) de C ou un groupe alkyle ramifié ou cyclique qui comporte de 3 à 10 atomes de C ou un système de cycle aromatique ou hétéroaromatique qui comporte de 5 à 24 atomes de cycle aromatique, lequel peut également être substitué par un radical ou par plusieurs radicaux $R^2$, où les deux groupes $R^1$ qui sont liés au même atome de carbone peuvent également former un cycle l'un avec l'autre et peuvent par conséquent former un système spiro, lequel peut être substitué par un radical ou par plusieurs radicaux $R^2$.

**6.** Dispositif électroluminescent organique selon une ou plusieurs des revendications 1 à 5, **caractérisé en ce que** le complexe d'iridium qui contient au moins un ligand benzoquinoline en option substitué est un composé de la formule (30),

$Ir(L)_m(L')_o$ formule (30)

dans laquelle $Ir(L)_m$ représente une structure de la formule (31) qui suit,

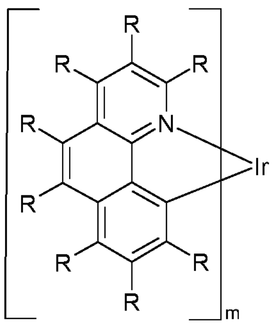

formule (31)

dans laquelle R présente les significations qui ont été données selon la revendication 1, mais des radicaux R adjacents ne peuvent pas former un système de cycle aromatique, et en outre :

L' est, de manière identique ou différente pour chaque occurrence, un ligand monoanionique bidenté ;
m est 1, 2 ou 3 ;
o est 3 - m.

**7.** Dispositif électroluminescent organique selon la revendication 6, **caractérisé en ce que** l'unité de la formule $M(L)_m$ est sélectionnée parmi les structures de la formule (31a),

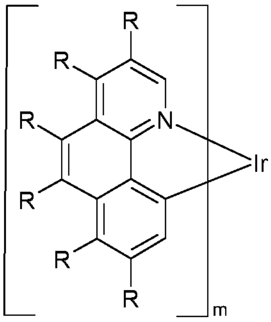

formule (31a)

dans laquelle les symboles et les indices qui sont utilisés présentent les significations qui ont été données selon la revendication 6.

**8.** Dispositif électroluminescent organique selon la revendication 6 ou 7, **caractérisé en ce que** R est sélectionné, de manière identique ou différente pour chaque occurrence, parmi le groupe qui est constitué par H, F, CN, un groupe alkyle en chaîne droite qui comporte de 1 à 6 atome(s) de C ou un groupe alkyle ramifié ou cyclique qui comporte de 3 à 6 atomes de C, lequel peut dans chaque cas être substitué par un radical ou par plusieurs radiaux $R^1$, ou un système de cycle aromatique ou hétéroaromatique qui comporte de 5 à 14 atomes de cycle aromatique, lequel peut dans chaque cas être substitué par un radical ou par plusieurs radicaux $R^1$, où deux substituants R adjacents ou plus peuvent en option former un système de cycle aliphatique monocyclique ou polycyclique, lequel peut être substitué par un radical ou par plusieurs radicaux $R^1$, où un maximum de trois substituants R dans le ligand L ne sont pas égaux à hydrogène.

**9.** Dispositif électroluminescent organique selon une ou plusieurs des revendications 6 à 8, **caractérisé en ce que** L' est sélectionné parmi les 1,3-dicétonates dérivés à partir des 1,3-dicétones, les 3-cétonates dérivés à partir des 3-cétoesters, les carboxylates dérivés à partir des acides aminocarboxyliques, les salicyliminates dérivés à partir des salicylimines, ou les ligands monoanioniques bidentés qui, avec le métal, forment un cycle à cinq éléments cyclométallisé ou un cycle à six éléments qui comporte au moins une liaison métal-carbone.

**10.** Dispositif électroluminescent organique selon une ou plusieurs des revendications 1 à 9, **caractérisé en ce qu'**il comprend une pluralité de couches d'émission, ce qui conduit au global à une émission blanche.

**11.** Procédé pour la production d'un dispositif électroluminescent organique selon une ou plusieurs des revendications 1 à 10, **caractérisé en ce qu'**au moins une couche est appliquée au moyen d'un procédé de sublimation et/ou **en ce qu'**au moins une couche est appliquée au moyen d'un procédé de dépôt organique en phase vapeur ou à l'aide d'une sublimation par gaz porteur et/ou **en ce qu'**au moins une couche est appliquée à partir d'une solution, par revêtement par centrifugation ou au moyen d'un processus d'impression.

**12.** Mélange comprenant au moins un complexe d'iridium qui contient au moins un ligand benzoquinoline en option substitué, et au moins un dérivé de triazine ou de pyrimidine qui présente un poids moléculaire d'au moins 350 g/mol, dans lequel le dérivé de triazine est un composé de la formule (1) et le dérivé de pyrimidine est un composé de la formule (2),

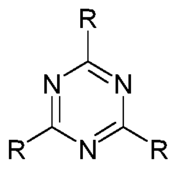

formule (1)

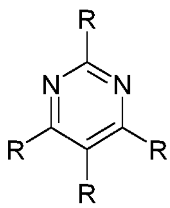

formule (2)

dans lesquelles ce qui suit s'applique aux symboles qui sont utilisés :

R est sélectionné pour chaque occurrence, de manière identique ou différente, parmi le groupe qui est constitué

par H, D, F, CN, $N(Ar)_2$, $N(R^1)_2$, C(=O)Ar, $C(=O)R^1$, $P(=O)(Ar)_2$, un groupe alkyle, alcoxy ou thioalkyle en chaîne droite qui comporte de 1 à 40 atome(s) de C ou un groupe alkyle, alcoxy ou thioalkyle ramifié ou cyclique qui comporte de 3 à 40 atomes de C ou un groupe alkényle ou alkynyle qui comporte de 2 à 40 atomes de C, lequel peut dans chaque cas être substitué par un radical ou par plusieurs radicaux $R^1$, où un ou plusieurs groupe(s) $CH_2$ non adjacents peut/peuvent être remplacé(s) par $R^1C{=}CR^1$, C≡C, $Si(R^1)_2$, C=O, C=S, $C{=}NR^1$, $P(=O)(R^1)$, SO, $SO_2$, $NR^1$, O, S ou $CONR^1$ et où un ou plusieurs atome(s) de H peut/peuvent être remplacé(s) par D, F, Cl, Br, I, CN ou $NO_2$, un système de cycle aromatique ou hétéroaromatique qui comporte de 5 à 80, de préférence de 5 à 60, atomes de cycle aromatique, lequel peut dans chaque cas être substitué par un radical ou par plusieurs radicaux $R^1$, un groupe aryloxy ou hétéroaryloxy qui comporte de 5 à 60 atomes de cycle aromatique, lequel peut être substitué par un radical ou par plusieurs radicaux $R^1$, ou un groupe aralkyle ou hétéroaralkyle qui comporte de 5 à 60 atomes de cycle aromatique, lequel peut être substitué par un radical ou par plusieurs radicaux $R^1$, où deux substituants R adjacents ou plus peuvent en option former un système de cycle aliphatique, aromatique ou hétéroaromatique monocyclique ou polycyclique, lequel peut être substitué par un radical ou par plusieurs radicaux $R^1$ ;

$R^1$ est sélectionné pour chaque occurrence, de manière identique ou différente, parmi le groupe qui est constitué par H, D, F, Cl, Br, I, CN, $NO_2$, $N(Ar)_2$, $N(R^2)_2$, C(=O)Ar, $C(=O)R^2$, $P(=O)(Ar)_2$, un groupe alkyle, alcoxy ou thioalkyle en chaîne droite qui comporte de 1 à 40 atome(s) de C ou un groupe alkyle, alcoxy ou thioalkyle ramifié ou cyclique qui comporte de 3 à 40 atomes de C ou un groupe alkényle ou alkynyle qui comporte de 2 à 40 atomes de C, lequel peut dans chaque cas être substitué par un radical ou par plusieurs radicaux $R^2$, où un ou plusieurs groupe(s) $CH_2$ non adjacents peut/peuvent être remplacé(s) par $R^2C{=}CR^2$, C≡C, $Si(R^2)_2$, C=O, C=S, $C{=}NR^2$, $P(=O)(R^2)$, SO, $SO_2$, $NR^2$, O, S ou $CONR^2$ et où un ou plusieurs atome(s) de H peut/peuvent être remplacé(s) par D, F, Cl, Br, I, CN ou $NO_2$, un système de cycle aromatique ou hétéroaromatique qui comporte de 5 à 60 atomes de cycle aromatique, lequel peut dans chaque cas être substitué par un radical ou par plusieurs radicaux $R^2$, un groupe aryloxy ou hétéroaryloxy qui comporte de 5 à 60 atomes de cycle aromatique, lequel peut être substitué par un radical ou par plusieurs radicaux $R^2$, ou un groupe aralkyle ou hétéroaralkyle qui comporte de 5 à 60 atomes de cycle aromatique, où deux substituants $R^1$ adjacents ou plus peuvent en option former un système de cycle aliphatique, aromatique ou hétéroaromatique monocyclique ou polycyclique, lequel peut être substitué par un radical ou par plusieurs radicaux $R^2$ ;

Ar est pour chaque occurrence, de manière identique ou différente, un système de cycle aromatique ou hétéroaromatique qui comporte de 5 à 30 atomes de cycle aromatique, lequel peut être substitué par un radical ou par plusieurs radicaux $R^2$ non aromatique(s) ; deux radicaux Ar qui sont liés au même atome de N ou au même atome de P peuvent également être pontés l'un à l'autre par une liaison simple ou un pont qui est sélectionné parmi $N(R^2)$, $C(R^2)_2$, O ou S ;

$R^2$ est sélectionné parmi le groupe qui est constitué par H, D, F, CN, un radical hydrocarbone aliphatique qui comporte de 1 à 20 atome(s) de C, un système de cycle aromatique ou hétéroaromatique qui comporte de 5 à 30 atomes de cycle aromatique, où un ou plusieurs atome(s) de H peut/peuvent être remplacé(s) par D, F, Cl, Br, I ou par CN, où deux substituants $R^2$ adjacents ou plus peuvent former un système de cycle aliphatique, aromatique ou hétéroaromatique monocyclique ou polycyclique l'un avec l'autre ou les uns avec les autres ;

**caractérisé en ce qu'**au moins un radical R représente un groupe de la formule (29),

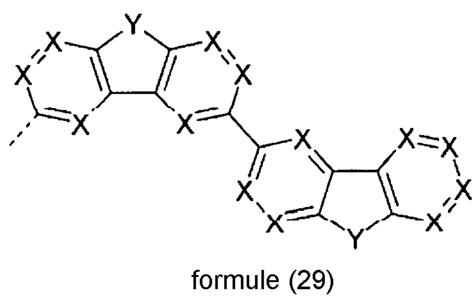

formule (29)

dans laquelle la liaison en pointillés représente la liaison sur l'unité de triazine dans la formule (1) ou sur l'unité de pyrimidine dans la formule (2) et en outre :

X est pour chaque occurrence, de manière identique ou différente, $CR^1$ ou N, où, de préférence, un maximum de 2 symboles X par cycle représentent N ;

Y est pour chaque occurrence, de manière identique ou différente, $C(R^1)_2$, $NR^1$, O, S ou $BR^1$, où $R^1$ présente

la signification qui a été mentionnée ci-avant.

**13.** Formulation comprenant au moins un mélange selon la revendication 12 et au moins un solvant organique.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 4539507 A
- US 5151629 A
- EP 0676461 A
- WO 9827136 A
- WO 2013084885 A
- WO 2013084881 A
- US 20130112920 A
- EP 1353388 A
- EP 1267428 A
- US 20010019782 A
- WO 2010108579 A
- WO 2004013080 A
- WO 2004093207 A
- WO 2006005627 A
- WO 2010006680 A
- WO 2005039246 A
- US 20050069729 A
- JP 2004288381 A
- EP 1205527 A
- WO 2008086851 A
- US 20090134784 A
- WO 2007063754 A
- WO 2008056746 A
- WO 2010136109 A
- WO 2011000455 A
- EP 1617710 A
- EP 1617711 A
- EP 1731584 A
- JP 2005347160 A
- WO 2007137725 A
- WO 2005111172 A
- WO 2006117052 A
- WO 2010054729 A
- WO 2010054730 A
- WO 2010015306 A
- EP 652273 A
- WO 2009062578 A
- WO 2009148015 A
- US 20090136779 A
- WO 2010050778 A
- WO 2011042107 A
- WO 2011088877 A
- WO 2011116865 A
- WO 2011137951 A
- WO 2013064206 A
- EP 12007040
- WO 2005053051 A
- WO 2002072714 A
- WO 2003019694 A


### In der Beschreibung aufgeführte Nicht-Patentliteratur


- **M. A. BALDO et al.** *Appl. Phys. Lett.,* 1999, vol. 75, 4-6
- **B. M. S. ARNOLD et al.** *Appl. Phys. Lett.,* 2008, vol. 92, 053301